(19)

**Europäisches Patentamt**
**European Patent Office**
**Office européen des brevets**

(11)  **EP 4 750 278 A1**

(12)  **EUROPEAN PATENT APPLICATION**
published in accordance with Art. 153(4) EPC

(43) Date of publication:
**27.05.2026 Bulletin 2026/22**

(21) Application number: **24842462.4**

(22) Date of filing: **01.08.2024**

(51) International Patent Classification (IPC):
**H10H 29/01** (2025.01)

(86) International application number:
**PCT/CN2024/109229**

(87) International publication number:
**WO 2025/016477 (23.01.2025 Gazette 2025/04)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **19.07.2023 CN 202310890109**

(71) Applicant: **Suzhou Qiushui Semiconductor Technology Co., Ltd.**
**Suzhou, Jiangsu 215000 (CN)**

(72) Inventors:
• **JIANG, Zhenyu**
  **Suzhou, Jiangsu 215000 (CN)**
• **WANG, Haifeng**
  **Suzhou, Jiangsu 215000 (CN)**

(74) Representative: **De Arpe Tejero, Manuel**
**Paseo de la Castellana 93b**
**28046 Madrid (ES)**

(54) **LED DISPLAY DEVICE AND MANUFACTURING METHOD FOR LED DISPLAY DEVICE**

(57) Disclosed in the present application are an LED display device and a manufacturing method for an LED display device. The LED display device comprises a driving substrate, a first light-emitting assembly and a second light-emitting assembly, wherein the driving substrate comprises a plurality of first pixel power supply electrodes and a plurality of second pixel power supply electrodes; the first light-emitting assembly comprises a first light-emitting layer group, a first pixel defining electrode and a second pixel defining electrode, the first pixel defining electrode cooperating with the first light-emitting layer group and the second pixel defining electrode to form a first pixel; and the second light-emitting assembly comprises a second light-emitting layer group, a third pixel defining electrode and a fourth pixel defining electrode, the third pixel defining electrode cooperating with the second light-emitting layer group and the fourth pixel defining electrode to form a second pixel, and the second pixel being staggered from the first pixel in the stacking direction of the first light-emitting assembly and the second light-emitting assembly. By means of said configurations, the present application can reduce the preparation difficulty of LED chips, and improve the yield of finished LED chips.

FIG. 1

EP 4 750 278 A1

## Description

The present application claims priority to Chinese Patent Application No. 2023108901096, entitled "LED DISPLAY DEVICE AND METHOD FOR MAKING LED DISPLAY DEVICE", filed on July 12, 2023, which is herein incorporated by reference in its entirety.

## TECHNICAL FIELD

The present disclosure relates to the technical field of display, and in particular to an LED display device and a method for making an LED display device.

## BACKGROUND

A light-emitting diode (LED) is a solid-state semiconductor device that is capable of transforming electrical energy into visible light, directly transforming electricity into light. In a case where current acts on an LED semiconductor chip through a wire, electrons and holes inside the LED semiconductor chip recombine, and then energy is emitted in the form of photons, thereby achieving light emission.

An LED chip usually has multiple pixel points, and a high-density pixel point integrated LED array can achieve precise control of a display effect of the LED chip. Nowadays, a method of setting multiple pixels usually relies on etching. An etching process for the LED chip is difficult to perform and is prone to damaging the LED chip, resulting in a low yield rate of finished LED chips. Furthermore, in order to achieve colorization, on the basis of etching to form pixels, LEDs with multiple colors are stacked and repeatedly etched, which increases difficulty and complexity of the process, making it difficult to achieve mass production of full-color LED display chips with both high yield and low cost.

## SUMMARY OF THE DISCLOSURE

The present disclosure provides an LED display device and a method for making an LED display device, which can reduce the difficulty of preparing an LED chip and improve yield of the LED chip.

In order to solve the above technical problem, a technical solution in the present disclosure is to provide an LED display device including a driving substrate, a first light-emitting assembly, and a second light-emitting assembly.

The driving substrate includes a plurality of first pixel power supply electrodes and a plurality of second pixel power supply electrodes.

The first light-emitting assembly includes a first light-emitting layer group, a plurality of first pixel defining electrodes, at least one second pixel defining electrode, and a plurality of first pixel transfer electrodes. The plurality of first pixel defining electrodes and the at least one second pixel defining electrode are disposed on two side surfaces of the first light-emitting layer group, respectively. Each first pixel defining electrode is disposed on a side surface of the first light-emitting layer group facing the driving substrate and configured to cooperate with the first light-emitting layer group and the second pixel defining electrode to form a first pixel. Each first pixel defining electrode is electrically connected to a corresponding first pixel power supply electrode, and the plurality of first pixel transfer electrodes pass through the first light-emitting layer group.

The second light-emitting assembly is stacked on a side of the first light-emitting assembly away from the driving substrate. The second light-emitting assembly includes a second light-emitting layer group, a plurality of third pixel defining electrodes, and at least one fourth pixel defining electrode. The plurality of third pixel defining electrodes and the at least one fourth pixel defining electrode are disposed on two side surfaces of the second light-emitting layer group, respectively. Each third pixel defining electrode is disposed on a side surface of the second light-emitting layer group facing the first light-emitting assembly and configured to cooperate with the second light-emitting layer group and the fourth pixel defining electrode to form a second pixel. In a stacking direction of the first light-emitting assembly and the second light-emitting assembly, a projection of the second pixel is staggered from a projection of the first pixel. Each third pixel defining electrode is electrically connected to a corresponding second pixel power supply electrode through a corresponding first pixel transfer electrode.

In order to solve the above technical problem, another technical solution in the present disclosure is to provide a method for making an LED display device, including:

    providing a driving substrate, wherein the driving substrate includes a plurality of first pixel power supply electrodes and a plurality of second pixel power supply electrodes;

    stacking a first light-emitting assembly on the driving substrate, wherein the first light-emitting assembly includes a first light-emitting layer group, a plurality of first pixel defining electrodes, at least one second pixel defining electrode, and a plurality of first pixel transfer electrodes; the plurality of first pixel defining electrodes and at least one second pixel defining electrode are disposed on two side surfaces of the first light-emitting layer group, respectively; each first pixel defining electrodes is disposed on a side surface of the first light-emitting layer group facing the driving substrate, and configured to cooperate with the first light-emitting layer group and the second pixel defining electrode to form a first pixel; and each first pixel defining electrode is connected to a corresponding first pixel power supply electrode, and the plurality of first pixel transfer electrodes pass through the first light-emitting layer group; and

    stacking the second light-emitting assembly on a side of the first light-emitting assembly away from the driving substrate, wherein the second light-emitting assembly includes a second light-emitting layer group, a plurality of third pixel defining electrodes, and at least one fourth pixel defining electrode; the plurality of third pixel defining electrodes and the at least one fourth pixel defining electrode are disposed on two side surfaces of the second light-emitting layer group, respectively; each third pixel defining electrode is disposed on a side surface of the second light-emitting layer group facing the first light-emitting assembly, and configured to cooperate with the second light-emitting layer group and the fourth pixel defining electrode to form a second pixel; in a stacking direction of the first light-emitting assembly and the second light-emitting assembly, a projection of the second pixel is staggered from that of the first pixel; and each third pixel defining electrode is electrically connected to a corresponding second pixel power supply electrode through a corresponding first pixel transfer electrode.

Different from related art, the effects of the present disclosure are as follows. In the present disclosure, the first light-emitting assembly and the second light-emitting assembly are stacked on the driving substrate, so that the first pixel and the second pixel are disposed on different planes, thereby reducing the preparation difficulty associated with the high-density pixel point integrated array in the same plane. This can reduce the difficulty of preparing the LED display device while ensuring the density of the display pixel points of the LED display device. Moreover, this can also reduce the risk of damaging the LED display device that is caused by excessive etching in the same planar component, thereby improving the yield of LED chips.

**BRIEF DESCRIPTION OF THE DRAWINGS**

FIG. 1 is a structural schematic view of an embodiment of an LED display device in the present disclosure.
FIG. 2 is an enlarged structural schematic view of a partial area O of the LED display device shown in FIG. 1.
FIG. 3 is an enlarged structural schematic view of a partial area P of the LED display device shown in FIG. 1.
FIG. 4 is a structural schematic view illustrating some assemblies of an embodiment of the LED display device in the present disclosure.
FIG. 5 is a structural schematic view of another embodiment of the LED display device in the present disclosure.
FIG. 6 is an enlarged structural schematic view of a partial area Q of the LED display device shown in FIG. 4.
FIG. 7 is a schematic view illustrating a preparation process of an embodiment of a method for making the LED display device in the present disclosure.
FIG. 8 is a schematic view illustrating another preparation process of an embodiment of the method for making the LED display device in the present disclosure.
FIG. 9 is a schematic view illustrating yet another preparation process of an embodiment of the method for the LED display device in the present disclosure.
FIG. 10 is a schematic view illustrating a preparation process of the LED display device shown in FIG. 1.
FIG. 11 is a schematic view illustrating another preparation process of the LED display device shown in FIG. 1.
FIG. 12 is a schematic view illustrating yet another preparation process of the LED display device shown in FIG. 1.
FIG. 13 is a schematic view illustrating yet another preparation process of the LED display device shown in FIG. 1.
FIG. 14 is a schematic view illustrating yet another preparation process of the LED display device shown in FIG. 1.
FIG. 15 is a structural schematic view of yet another embodiment of the LED display device in the present disclosure.
FIG. 16 is a schematic view illustrating a preparation process of the LED display device shown in FIG. 4.
FIG. 17 is a schematic view illustrating another preparation process of the LED display device shown in FIG. 4.
FIG. 18 is a schematic view illustrating yet another preparation process of the LED display device shown in FIG. 4.
FIG. 19 is a schematic view illustrating yet another preparation process of the LED display device shown in FIG. 4.

**DETAILED DESCRIPTION**

The technical solutions in some embodiments of the present disclosure may be clearly and completely described in conjunction with accompanying drawings in some embodiments of the present disclosure. Obviously, the described embodiments are only a part of the embodiments of the present disclosure, and not all embodiments. Based on the embodiments in the present disclosure, all other embodiments obtained by those of ordinary skill in the art without creative effort are within the scope of the present disclosure.

The inventors of the present disclosure have found that a light-emitting diode (LED) chip usually has multiple pixel points, and a high-density pixel point integrated LED array can achieve precise control of a display effect of the LED chip. Nowadays, a method of setting multiple pixels usually relies on etching. An etching process for the LED chip is difficult to perform and is prone to damaging the LED chip, resulting in a low yield rate of finished LED chips. Furthermore, in order to achieve colorization, on the basis of etching to form pixels, LEDs with multiple colors are stacked and repeatedly etched, which increases difficulty and complexity of the process, making it difficult to achieve mass production of full-color LED display chips with both high yield and low cost. Therefore, the present disclosure provides the following embodiments of LED display devices.

The following embodiments of the present disclosure describe exemplary structures of the LED display devices.

An LED display device 1 is a device that is able to form multiple display pixel points inside the device to generate light, and the generated light may be emitted from a surface of the LED display device 1, so as to illuminate or display various information such as text, images, videos, etc. In some embodiments, the LED display device 1 may be an LED digital automotive light chip, a digital light strip chip, an LED display screen chip, or other devices.

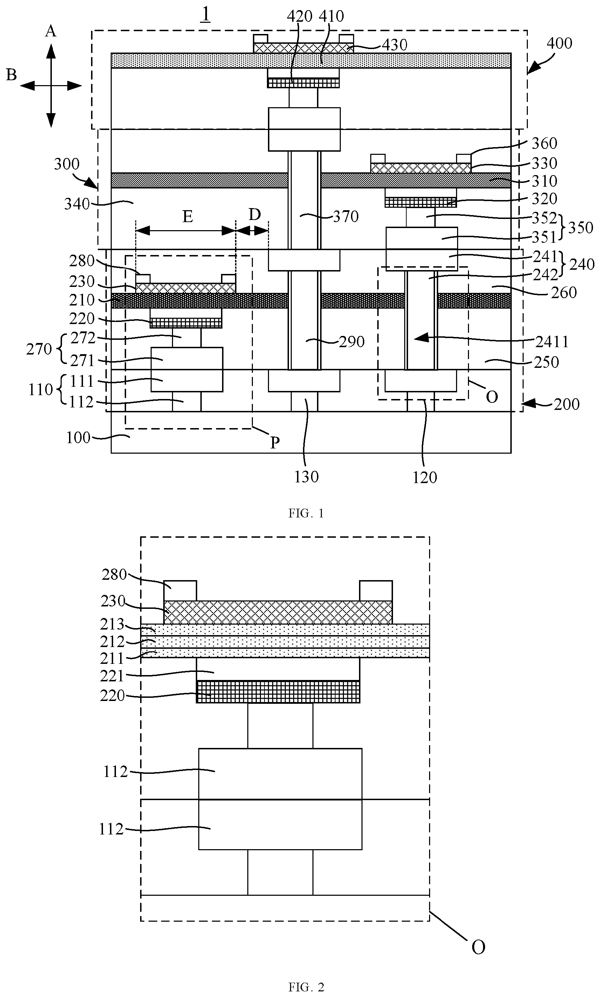

As shown in FIG. 1, the LED display device 1 may include a driving substrate 100, a first light-emitting assembly 200, and a second light-emitting assembly 300.

The driving substrate 100 is electrically connected to the first light-emitting assembly 200 and the second light-emitting assembly 300. The driving substrate 100 is configured to provide driving current to the first light-emitting assembly 200 and the second light-emitting assembly 300. The first light-emitting assembly 200 and the second light-emitting assembly 300 are configured to receive the driving current of the driving substrate 100 and achieve a display light-emitting function. In some embodiments, the driving substrate 100, the first light-emitting assembly 200, and the second light-emitting assembly 300 may be sequentially stacked. A stacking direction may be shown by an arrow of FIG. 1.

In some embodiments, the first light-emitting assembly 200 may be fixed on the driving substrate 100 by metal bonding or hybrid bonding. The second light-emitting assembly 300 may also be fixed on a side of the first light-emitting assembly 200 away from the driving substrate 100 by the metal bonding or the hybrid bonding.

In some embodiments, a contact area between the first light-emitting assembly 200 and the driving substrate 100, and a contact area between the second light-emitting assembly 300 and the driving substrate 100 may be made of metal materials, so that metal atoms of the first light-emitting assembly 200 and the second light-emitting assembly 300 can be combined with metal atoms of the driving substrate 100, thereby achieving metal bonding between metals. Metal bonding connections can facilitate good electrical and thermal conductivity between the first light-emitting assembly 200 and the driving substrate 100, and between the second light-emitting assembly 300 and the driving substrate 100.

A hybrid bonding mode involves dielectric-to-dielectric bonding in some areas and metal-to-metal bonding in other areas. That is, two types of materials are bonded together in a hybrid manner, thereby forming an interconnected permanent bond. The hybrid bonding can not only achieve face-to-face bonding of wafers, but also increase strength, density, and reliability of bonding. The hybrid bonding mode can facilitate face-to-face connection and bonding of each of the first light-emitting assembly 200 and the second light-emitting assembly 300 to the driving substrate 100.

In some embodiments, other bonding methods may also be configured to bond each of the first light-emitting assembly 200 and the second light-emitting assembly 300 to the driving substrate 100, which is not limited in the embodiments.

In some embodiments, the driving substrate 100 may include multiple first pixel power supply electrodes 110 and multiple second pixel power supply electrodes 120. The multiple first pixel power supply electrodes 110 may correspond to and be connected to the first light-emitting assembly 200, so as to transmit the driving current to the first light-emitting assembly 200. The multiple second pixel power supply electrodes 120 may correspond to and be connected to the second light-emitting assembly 300, so as to transmit the driving current to the second light-emitting assembly 300.

In some embodiments, the driving substrate 100 may include multiple switch devices (not shown in figures) arranged in an array. The multiple switch devices correspond one-to-one and are electrically connected to the multiple first pixel power supply electrodes 110 and the multiple second pixel power supply electrodes 120. By disposing the switch devices to be electrically connected to the first pixel power supply electrodes 110 and the second pixel power supply electrodes 120, individual control of display pixels in the LED display device 1 can be further achieved.

In some embodiments, the first light-emitting assembly 200 may include a first light-emitting layer group 210, multiple first pixel defining electrodes 220, at least one second pixel defining electrode 230, and multiple first pixel transfer electrodes 240.

The first pixel defining electrode 220 and the second pixel defining electrode 230 may be disposed on two side surfaces of the first light-emitting layer group 210. The first pixel defining electrode 220 is disposed on a side surface of the first light-emitting layer group 210 facing the driving substrate 100. The first pixel defining electrode 220 respectively cooperates with the first light-emitting layer group 210 and the second pixel defining electrode 230 to form a first pixel. Each first pixel defining electrode 220 may be electrically connected to a corresponding first pixel power supply electrode 110, and the first pixel transfer electrode 240 may pass through the first light-emitting layer group 210.

In some embodiments, the first light-emitting layer group 210 may be an epitaxial layer that is able to achieve light-emitting by recombination of electrons and holes under support of the driving current. The first light-emitting layer group 210 may include a P-type semiconductor and a N-type semiconductor. The first pixel defining electrode 220 and the second pixel defining electrode 230 may be a P electrode and a N electrode of the first pixel, respectively. The first pixel defining electrode 220 and the second pixel defining electrode 230 can form an ohmic contact with the first light-emitting layer group 210 on two sides of the first light-emitting layer group 210, so as to provide current to the P-type semiconductor and the N-type semiconductor of the first light-emitting layer group 210. Therefore, through mutual cooperation of the first pixel defining electrode 220, the second pixel defining electrode 230, and the first light-emitting layer group 210, the first light-emitting layer group 210 is able to display multiple first pixels.

The multiple first pixel defining electrodes 220 may be arranged in an array on the side surface of the first light-emitting layer group 210 facing the driving substrate 100 according to a required position of the first pixel, and positions of the multiple first pixel power supply electrodes 110 correspond one-to-one with positions of the multiple first pixel defining electrodes 220. Therefore, the first light-emitting layer group 210 is able to receive the driving current transmitted by the first pixel defining electrodes 220 at positions corresponding to the multiple first pixel defining electrodes 220, thereby enabling the first light-emitting layer group 210 to display the multiple first pixels at specific positions.

The multiple first pixel transfer electrodes 240 pass through the first light-emitting assembly 200 in the stacking direction of the first light-emitting assembly 200 and the second light-emitting assembly 300, and are exposed at two ends of the first light-emitting assembly 200. One end of the first pixel transfer electrode 240 is in contact with the driving substrate 100, and another end of the first pixel transfer electrode 240 is in contact with the second light-emitting assembly 300. The multiple first pixel transfer electrodes 240 are configured to transmit the driving current of the driving substrate 100 to the second light-emitting assembly 300.

The second light-emitting assembly 300 may be stacked on a side of the first light-emitting assembly 200 away from the driving substrate 100. The second light-emitting assembly 300 may include a second light-emitting layer group 310, multiple third pixel defining electrodes 320, and at least one fourth pixel defining electrode 330. The multiple third pixel defining electrodes 320 and the at least one fourth pixel defining electrode 330 are disposed on two side surfaces of the second light-emitting layer group 310, respectively.

The third pixel defining electrode 320 may be disposed on a side surface of the second light-emitting layer group 310 facing the first light-emitting assembly 200. The third pixel defining electrode 320 respectively cooperates with the second light-emitting layer group 310 and the fourth pixel defining electrode 330 to form a second pixel. In the stacking direction of the first light-emitting assembly 200 and the second light-emitting assembly 300, a projection of the second pixel and a projection of the first pixel are disposed in a staggered manner. Each third pixel defining electrode 320 is electrically connected to a corresponding second pixel power supply electrode 120 through a corresponding first pixel transfer electrode 240.

Similarly, the second light-emitting layer group 310 may be the epitaxial layer that is able to achieve the light-emitting by recombination of the electrons and the holes under the support of the driving current. The second light-emitting layer group 310 may also include the P-type semiconductor and the N-type semiconductor. The third pixel defining electrode 320 and the fourth pixel defining electrode 330 may be a P electrode and a N electrode of the second pixel, respectively. The third pixel defining electrode 320 and the fourth pixel defining electrode 330 are able to form the ohmic contact with the second light-emitting layer group 310 on two side surfaces of the second light-emitting layer group 310. Therefore, through mutual cooperation of the third pixel defining electrode 320, the fourth pixel defining electrode 330, and the second light-emitting layer group 310, the second light-emitting layer group 310 is able to display multiple second pixels.

In some embodiments, the multiple third pixel defining electrodes 320 may be arranged in an array on the side surface of the second light-emitting layer group 310 facing the driving substrate 100 according to required position of the second pixel, and positions of the multiple second pixel power supply electrodes 120 correspond one-to-one with positions of the multiple second pixel defining electrodes 230. Therefore, the second light-emitting layer group 310 is able to receive the driving current transmitted by the second pixel defining electrodes 230 through the first pixel transfer electrodes 240 at positions corresponding to the multiple second pixel defining electrodes 230, thereby enabling the second light-emitting layer group 310 to display multiple second pixels at specific positions.

In some embodiments, each of the first pixel defining electrode 220 and the third pixel defining electrode 320 may be formed of a conductive material such as an indium tin oxide (ITO) metal, an Ag metal, or a Ni metal, etc. Each of the first pixel power supply electrode 110, the second pixel power supply electrode 120, and the first pixel transfer electrode 240 may be formed of a conductive material such as Cu, Au, Al, etc. Therefore, in some embodiments, the first pixel defining electrode 220 may form a metal bonding structure with the first pixel power supply electrode 110, and the metal bonding structure may be Ni/Al/Pt/Au, ITO/Ag/Ti/Pt/Au, etc. The first pixel transfer electrode 240 may form the metal bonding structures with the second pixel power supply electrode 120 and the third pixel defining electrode 320 at its two ends, and the metal bonding structure may be Ni/Al/Pt/Au, ITO/Ag/Ti/Pt/Au, etc.

In some embodiments, the first light-emitting layer group 210 may be provided with an insulating area (not shown in the figures) that is formed by ion bombardment, and the insulating area is disposed on periphery of the first pixel transfer electrode 240. This can prevent the current in the first pixel transfer electrode 240 from leaking to the first light-emitting layer group 210 and affecting the first pixel, thereby reducing electrical crosstalk between display pixels. Therefore, the driving substrate 100 can accurately control the third pixel defining electrode 320 through the first pixel transfer electrode 240, so as to control a display effect of the second pixel.

In some embodiments, as shown in FIGS. 1 and 2, the first light-emitting layer group 210 may include a first semiconductor layer 211, a first active layer 212, and a second semiconductor layer 213 stacked in sequence. The first semiconductor layer 211 is disposed on a side surface of the first active layer 212 facing the driving substrate 100. The first semiconductor layer 211 may serve as the P-type semiconductor of the first light-emitting layer group 210 and be electrically connected to the first pixel defining electrode 220. The second semiconductor layer 213 may serve as the N-type semiconductor of the first light-emitting layer group 210 and be electrically connected to the second pixel defining electrode 230. The first active layer 212 is a multi-layer quantum well light-emitting layer. The electrons may recombine with holes in the first semiconductor layer 211, so as to emit light in the first active layer 212. Each of the first semiconductor layer 211 and the second semiconductor layer 213 may be formed by doping in a semiconductor material, and the semiconductor material may be AlN, AlGaN, GaN, InGaN, AlInGaN, GaAs, GaP, GaInN, GaAsP, AlGaAs, or AlGaInP, etc.

In some embodiments, a thickness and resistivity of the first semiconductor layer 211 are set, so that during normal operation of the LED display device 1, a lateral current diffusion length of the first semiconductor layer 211 satisfies: $Ls \leq 1/2 \times D1$, wherein Ls is the lateral current diffusion length of the first semiconductor layer 211, and D1 is a shortest distance between an edge of a part of the first pixel transfer electrode 240 disposed in the first light-emitting layer group 210 and an edge of the first pixel defining electrode 220 adjacent to the first pixel transfer electrode 240.

The lateral current diffusion length Ls of the first semiconductor layer 211 is calculated by the following formula:

$$Ls = \sqrt{(kT/e \times t/(\rho J\_0))} \qquad (1)$$

wherein, k is a Boltzmann constant, T is a thermodynamic temperature, e is elementary charge, t is the thickness of the first semiconductor layer 211, $\rho$ is the resistivity of the first semiconductor layer 211, and J_0 is current density in a first current diffusion layer covered by the first pixel defining electrode 220 during the normal operation of the LED display device 1. It can be seen that the lateral current diffusion length Ls decreases with decrease of the thickness t of the first semiconductor layer 211, and decreases with increase of the resistivity $\rho$ of the first semiconductor layer 211. Therefore, the lateral current diffusion length Ls may be reduced, so as to prevent operating current of the display pixel corresponding to each first pixel defining electrode 220 from diffusing to the position of the adjacent first pixel transfer electrode 240, thereby achieving self- isolation between each first pixel and the first pixel transfer electrode 240, and reducing the electrical crosstalk between the first pixel and the second pixel.

In some embodiments, as shown in FIGS. 1 to 3, a through hole 2411 may be defined on the first light-emitting layer group 210, and the first pixel transfer electrode 240 may pass through the through hole 2411. A hole wall insulation layer 2412 may be disposed on a hole wall of the through hole 2411. The hole wall insulation layer 2412 may be an insulation layer made of an insulation material such as silicon dioxide, silicon nitride, or aluminum oxide, etc. By using the hole wall insulation layer 2412, the first pixel transfer electrode 240 can be directly separated from the first light-emitting layer group 210, and a preparation process is simple. The cost of the LED display device 1 can be reduced while reducing the electrical crosstalk between the first pixel and the second pixel.

In some embodiments, in a vertical direction of the stacking direction, the distance from the edge of the part of the first pixel transfer electrode 240 disposed in the first light-emitting layer group 210 to the edge of the first pixel defining electrode 220 may be greater than or equal to one- fourth of a size of the first pixel defining electrode 220 in the vertical direction.

In some embodiments, in the vertical direction of the stacking direction, the distance from the edge of the part of the first pixel transfer electrode 240 disposed in the first light-emitting layer group 210 to the edge of the second pixel defining electrode 230 is greater than or equal to one-fourth of a size of the second pixel defining electrode 230 in the vertical direction.

In some embodiments, as shown in FIG. 1, the stacking direction of the first light-emitting assembly 200 and the second light-emitting assembly 300 is shown by the arrow A of FIG. 1, and the vertical direction of the stacking direction is shown by an arrow B of FIG. 1. The distance from the edge of the part of the first pixel transfer electrode 240 disposed in the first light-emitting layer group 210 to the edge of the second pixel defining electrode 230 may be defined as the distance D in the FIG. 1, the size of the second pixel defining electrode 230 in the vertical direction may be defined as E in the FIG. 1, and D is greater than or equal to E/4.

Through the above settings, the first pixel transfer electrode 240 is not prone to experiencing current leakage to the position of the first pixel, thereby further reducing the electrical crosstalk between the first pixel and the second pixel, improving reliability and yield of the LED display device 1, and reducing probability of the current leakage.

In some embodiments, as shown in FIG. 1, the first light-emitting assembly 200 may further include a first interlayer insulation layer 250, a second interlayer insulation layer 260, and a first pixel extraction electrode 270. The first interlayer insulation layer 250 may cover a side surface of the first light-emitting layer group 210 facing the driving substrate 100 and the first pixel defining electrode 220. An end of the first pixel extraction electrode 270 is electrically connected to the first pixel defining electrode 220, and another end of the first pixel extraction electrode 270 is exposed from a side surface of the first interlayer insulation layer 250 facing the driving substrate 100. The first pixel extraction electrode 270 and the first pixel power supply electrode 110 are bonded and connected to each other. The second interlayer insulation layer 260 may cover a side surface of the first light-emitting layer group 210 away from the driving substrate 100 and the second pixel defining electrode 230. The first pixel transfer electrode 240 further passes through the first interlayer insulation layer 250 and the second interlayer insulation layer 260.

The first pixel extraction electrode 270 may be made of the conductive material such as Cu, Au, or Al, etc. The first pixel extraction electrode 270 may form the metal bonding with the first pixel power supply electrode 110 via copper, indium, gold, or tin. In some embodiments, the hybrid bonding between the insulating material and the metal material may also be achieved using a mode such as $SiO_2$/Cu, PI/Cu, or BCB/Cu, etc., which is not limited in the present disclosure.

In some embodiments, the first pixel extraction electrode 270 may be embedded in the first interlayer insulation layer 250. A surface of the first pixel extraction electrode 270 facing the driving substrate 100 may be flush with a surface of the first interlayer insulation layer 250 facing the driving substrate 100. Therefore, after a dielectric layer is bonded, it may be annealed and diffused at a high temperature, so that the first pixel extraction electrode 270 is bonded and connected to the first pixel power supply electrode 110.

The first interlayer insulation layer 250 covers the side surface of the first light-emitting layer group 210 facing the driving substrate 100 and the first pixel defining electrode 220, which can further fix the first pixel defining electrode 220, the first pixel extraction electrode 270, and the first pixel transfer electrode 240. This further stabilizes the positions of the first pixel and the second pixel, thereby making a structure of the LED display device 1 more compact.

Each of the first interlayer insulation layer 250 and the second interlayer insulation layer 260 may be made of the insulating material such as the silicon dioxide, BCB, PI, etc. This setting can reduce the current leakage and the crosstalk between display pixels. The first interlayer insulation layer 250 may also serve as a masking film and a protective layer to avoid diffusion of an impurity, thereby preventing the impurity from falling into an interior of the LED display device 1 and affecting its operation.

In some embodiments, the second interlayer insulation layer 260 may be made of a transparent insulation material. During the first light-emitting layer group 210 being energized to emit light, the light emitted from the first light-emitting layer group 210 passes through the second interlayer insulation layer 260 to be emitted outward. Therefore, setting the second interlayer insulation layer 260 as a transparent insulation layer can reduce light loss and improve light extraction efficiency of the LED display device 1.

Similarly, in some embodiments, the second light-emitting assembly 300 may further include a third interlayer insulation layer 340 and a second pixel extraction electrode 350. The third interlayer insulation layer 340 covers a side surface of the second light-emitting layer group 310 facing the first light-emitting layer group 210 and the third pixel defining electrode 320. An end of the second pixel extraction electrode 350 is electrically connected to the third pixel defining electrode 320, and another end of the second pixel extraction electrode 350 is exposed from a side surface of the third interlayer insulation layer 340 facing the first light-emitting layer group 210. The second pixel extraction electrode 350 is bonded and connected to the first pixel transfer electrode 240.

In some embodiments, the second pixel extraction electrode 350 is embedded in the third interlayer insulation layer 340, and a surface of the second pixel extraction electrode 350 facing the first light-emitting assembly 200 may be flush with a surface of the third interlayer insulation layer 340 facing the first light-emitting assembly 200. The first pixel transfer electrode 240 is exposed on a side surface of the second interlayer insulation layer 260 facing the second light-emitting layer group 310, and may be flush with the side surface of the second interlayer insulation layer 260 facing the second light-emitting layer group 310. This facilitates stacking of the first light-emitting assembly 200 and the second light-emitting assembly 300, and facilitates a bonding connection between the second pixel extraction electrode 350 and the first pixel transfer electrode 240.

Similarly, the second pixel extraction electrode 350 may be made of the conductive material such as Cu, Au, or Al, etc. The second pixel extraction electrode 350 may form the metal bonding with the first pixel transfer electrode 240 via copper, indium, gold, or tin, etc. The third interlayer insulation layer 340 may also be made of the transparent insulation material such as the silicon dioxide, the PI, the BCB, etc., so that the light emitted by the first pixel and the second pixel can pass through the third interlayer insulation layer 340 to exit the LED display device 1.

In some embodiments, as shown in FIG. 1, the first pixel power supply electrode 110 may include a first pixel power supply part 111 and a second pixel power supply part 112 connected to each other. The first pixel extraction electrode 270 may include a first pixel extraction part 271 and a second pixel extraction part 272 connected to each other.

In the vertical direction of the stacking direction, a size of the first pixel power supply part 111 may be greater than that of the second pixel power supply part 112, and a size of the first pixel extraction part 271 may be greater than that of the second pixel extraction part 272. The first pixel power supply part 111 and the first pixel extraction part 271 are bonded to each other, and the second pixel power supply part 112 is electrically connected to the first pixel defining electrode 220. By increasing a contact area of a part where the first pixel power supply electrode 110 and the first pixel extraction electrode 270 are bonded to each other, a double-layer damascene structure can be formed. This facilitates the mutual bonding between the first pixel power supply electrode 110 and the first pixel extraction electrode 270, thereby achieving a higher strength connection.

Similarly, in some embodiments, the second pixel extraction electrode 350 may include a third pixel extraction part 351 and a fourth pixel extraction part 352 connected to each other, and the first pixel transfer electrode 240 may include a first pixel transfer part 241 and a second pixel transfer part 242 connected to each other. In the vertical direction of the stacking direction, a size of the first pixel transfer part 241 is greater than that of the second pixel transfer part 242, and a size of the third pixel extraction part 351 is greater than that of the fourth pixel extraction part 352. The first pixel transfer part 241 and the third pixel extraction part 351 are bonded to each other, and the fourth pixel extraction part 352 is electrically connected to the third pixel defining electrode 320.

In some embodiments, the first pixel power supply electrode 110 and the first pixel power supply electrode 110 may have the same size, and the second pixel extraction electrode 350 and the first pixel transfer part 241 may have the same size, so that single-layer damascene structures are formed, which is not limited in the present disclosure.

In some embodiments, conductive connections may be formed by deposition between the second pixel extraction part 272 and the first pixel defining electrode 220, between the fourth pixel extraction part 352 and the third pixel defining electrode 320, and between the second pixel transfer part 242 and the second pixel power supply electrode 120, respectively. In other words, the second pixel extraction part 272 may be formed in the first light-emitting assembly 200 by deposition, and the second pixel extraction part 272 is electrically connected to the first pixel defining electrode 220. Similarly, the fourth pixel extraction part 352 may be formed in the second light-emitting assembly 300 by deposition, and the fourth pixel extraction part 352 is electrically connected to the third pixel defining electrode 320. The second pixel transfer part 242 may be formed in the first light-emitting assembly 200 by deposition, and the second pixel transfer part 242 is electrically connected to the second pixel power supply electrode 120.

The use of deposition can facilitate formation of the second pixel extraction part 272, the fourth pixel extraction part 352, and the second pixel transfer part 242, thereby reducing difficulty of preparing the LED display device 1. It can also enhance the conductive connections between the second pixel extraction part 272 and the first pixel defining electrode 220, between the fourth pixel extraction part 352 and the third pixel defining electrode 320, and between the second pixel transfer part 242 and the second pixel power supply electrode 120.

In some embodiments, as shown in FIGS. 1 to 4, the number of the second pixel defining electrodes 230 is multiple and corresponds to the number of the first pixel defining electrodes 220. The first light-emitting assembly 200 may further include a first interconnecting electrode 280 that is electrically connected to the multiple second pixel defining electrodes 230. In some embodiments, the multiple second pixel defining electrodes 230 correspond one-to-one with the multiple first pixel defining electrodes 220. The multiple second pixel defining electrodes 230 and the first interconnecting electrode 280 together form a common N electrode of the first light-emitting layer group 210. The first interconnecting electrode 280 is a grid-shaped interconnecting electrode that is connected to all second pixel defining electrodes 230 and may cooperate with the first light-emitting layer group 210 to form the first pixel.

By connecting the multiple second pixel defining electrodes 230 to the first interconnecting electrode 280, a reference voltage can be supplied to all second pixel defining electrodes 230 by supplying the reference voltage to the first interconnecting electrode 280. This achieves unified control of the multiple second pixel defining electrodes 230, thereby controlling the display of the first pixel on the LED display device 1.

In some embodiments, the number of the fourth pixel defining electrodes 330 may be multiple and correspond to the number of the third pixel defining electrodes 320. The second light-emitting assembly 300 may further include a second interconnecting electrode 360 that is electrically connected to the multiple fourth pixel defining electrodes 330. Similarly, the second interconnecting electrode 360 is connected to the multiple fourth pixel defining electrodes 330 corresponding to the multiple second pixels, which can achieve unified control of the multiple fourth pixel defining electrodes 330, thereby controlling the display of the second pixel on the LED display device 1.

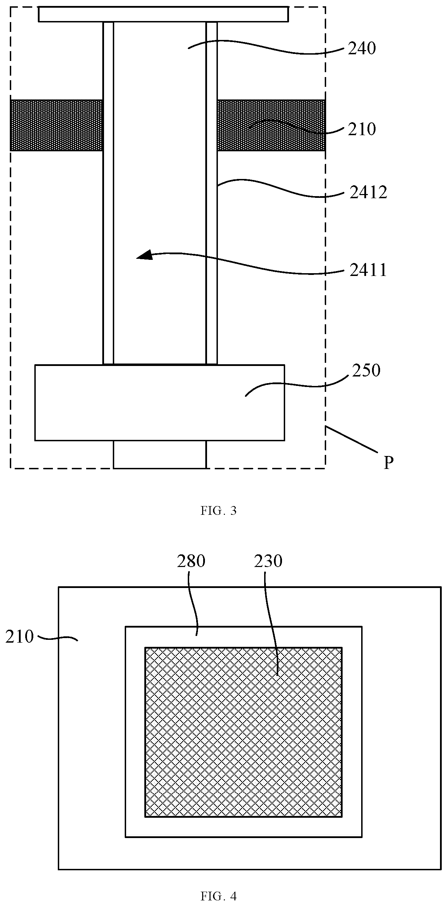

In some embodiments, as shown in FIG. 4, the first interconnecting electrode 280 may be the grid-shaped and cover a part of the second pixel defining electrode 230 along an edge of the second pixel defining electrode 230. This setting not only reduces the preparation cost of the LED display device 1, but also makes it less likely for the first interconnecting electrode 280 to be in contact with the first pixel transfer electrode 240, thereby avoiding the current leakage and ensuring feasibility and the yield of the LED display device 1.

In some embodiments, reflectivity of the second pixel defining electrode 230 may be less than that of the first pixel defining electrode 220, and a thickness of the first light-emitting layer group 210 is controlled, so as to form a first resonant cavity emitting light from a side of the second pixel defining electrode 230.

By setting in this way, in a case where the first light-emitting layer group 210 emits light under the action of the driving voltage and the reference voltage, the light generated by the first light-emitting layer group 210 can be reflected by the first pixel defining electrode 220 with higher reflectivity and emitted from the second pixel defining electrode 230 with lower reflectivity, so that the light output from the first pixel is more collimated, thereby improving the light extraction efficiency of the LED display device 1.

In some embodiments, similarly, reflectivity of the fourth pixel defining electrode 330 may be less than that of the third pixel defining electrode 320, and a thickness of the second light-emitting layer group 310 is controlled, so as to form a second resonant cavity emitting light from a side of the fourth pixel defining electrode 330. The second interconnecting electrode 360 may be grid-shaped and cover a part of the fourth pixel defining electrode 330 along an edge of the fourth pixel defining electrode 330.

In some embodiments, each of the first pixel defining electrode 220 and the third pixel defining electrode 320 may be made of a material with high reflective, such as silver or aluminum, etc. Each of the second pixel defining electrode 230 and the fourth pixel defining electrode 330 may be made of the material such as Al, Ti, Ni, etc. Each of the second pixel defining electrode 230 and the fourth pixel defining electrode 330 may be made of a dielectric layer distributed Bragg reflector (DBR).

This setting can ensure collimated light emission from each pixel of the LED display device 1 and reduce the current leakage, thereby improving the light extraction efficiency and the yield of the LED display device 1.

In some embodiments, as shown in FIG. 1, a transparent electrode layer 221 may be disposed between the first pixel defining electrode 220 and the first light-emitting layer group 210. The transparent electrode layer 221 forms the ohmic contact with the first light-emitting layer group 210, and the first pixel defining electrode 220 forms the ohmic contact with the transparent electrode layer 221, together serving as the P electrode of the first pixel. The transparent electrode layer 221 may be made of a material such as the ITO electrode, etc. Other display pixels may also be set in this way, so that the transparent electrode layer 221 serves as the main P electrode to transmit current to the first light-emitting layer group 210, so as to select a high reflective material as the first pixel defining electrode 220.

In some embodiments, a wavelength of output light from the first light-emitting assembly 200 may be greater than a wavelength of output light from the second light-emitting assembly 300. In some embodiments, the first light-emitting assembly 200 may emit green light, and the second light-emitting assembly 300 may emit blue light, and a wavelength of the green light is greater than a wavelength of the blue light. The wavelength of the output light from the first light-emitting assembly 200 and the wavelength of the output light from the second light-emitting assembly 300 are set to be different, which can enable the LED display device 1 to obtain the display pixels that are able to display different colors, thereby enriching the display effect of the LED display device 1.

In some embodiments, based on the structural form of the second pixel, other display pixels may be added to the LED display device 1.

In some embodiments, as shown in FIG. 1, the driving substrate 100 may further include multiple third pixel power supply electrodes 130. The first light-emitting assembly 200 may further include a second pixel transfer electrode 290 passing through the first light-emitting layer group 210. The second light-emitting assembly 300 further includes a third pixel transfer electrode 370 passing through the second light-emitting layer group 310, and the third pixel transfer electrode 370 is aligned with and connected to the second pixel transfer electrode 290.

The LED display device 1 may further include a third light-emitting assembly 400. The third light-emitting assembly 400 may be stacked on a side of the second light-emitting assembly 300 away from the first light-emitting assembly 200. The third light-emitting assembly 400 includes a third light-emitting layer group 410, multiple fifth pixel defining electrodes 420, and at least one sixth pixel defining electrode 430. The multiple fifth pixel defining electrodes 420 and the at least one sixth pixel defining electrode 430 are disposed on two side surfaces of the third light-emitting layer group 410, respectively. The fifth pixel defining electrode 420 is disposed on a side surface of the third light-emitting layer group 410 facing the second light-emitting assembly 300, and cooperates with the third light-emitting layer group 410 and the sixth pixel defining electrode 430 to form a third pixel.

A projection of the third pixel, the projection of the first pixel, and the projection of the second pixel in the stacking direction are disposed in the staggered manner. The fifth pixel defining electrode 420 is electrically connected to a corresponding third pixel power supply electrode 130 through the second pixel transfer electrode 290 and the third pixel transfer electrode 370.

In some embodiments, the wavelength of the output light from the first light-emitting assembly 200 may be greater than the wavelength of the output light from the second light-emitting assembly 300, and the wavelength of the output light from the first light-emitting assembly 200 may be less than a wavelength of output light from the third light-emitting assembly 400. In some embodiments, the output light of the first light-emitting assembly 200 may be the green light, the output light of the second light-emitting assembly 300 may be the blue light, and the output light of the third light-emitting assembly 400 may be red light. The wavelength of the red light is greater than that of the green light, and the wavelength of the green light is greater than that of the blue light. This can further enrich the display effect of the LED display device 1.

Through the above settings, in the present disclosure, a stacking method is adopted to arrange the display pixels with different output light wavelengths on different planes, thereby reducing the preparation difficulty of high-density pixel point integrated arrays in the same plane. This can ensure density of the pixel points of the LED display device 1 while reducing the preparation difficulty of the LED display device 1 with multiple colors. Moreover, this can also reduce the risk of damaging the LED display device 1 that is caused by excessive etching in the same planar component, thereby improving the yield of LED chips.

In some embodiments, in a stacking direction of the third light-emitting assembly 400 and the second light-emitting assembly 300, the sixth pixel defining electrode 430, the fifth pixel defining electrode 420, the third pixel transfer electrode 370, the second pixel transfer electrode 290, and the third pixel power supply electrode 130 are stacked in sequence and electrically connected to each other. In the stacking direction of the third light-emitting assembly 400 and the second light-emitting assembly 300, a projection of the sixth pixel defining electrode 430, a projection of the fifth pixel defining electrode 420, a projection of the third pixel transfer electrode 370, a projection of the second pixel transfer electrode 290, and a projection of the third pixel power supply electrode 130 overlap. Therefore, the fifth pixel defining electrode 420 is able to receive the driving current provided by the third pixel power supply electrode 130, so as to drive the third pixel to emit light.

Similarly, a specific structure of the third light-emitting assembly 400 may refer to the structure of the second light-emitting assembly 300, which is not repeated in the embodiments of the present disclosure.

In some embodiments, an insulation layer may be disposed on a side surface of the second light-emitting assembly 300 away from the first light-emitting assembly 200, so as to cover the second interconnecting electrode 360 and the fourth pixel defining electrode 330. Then, a hole may be defined on an area of the insulation layer that corresponds to the third pixel power supply electrode 130 through deep etching, and the second pixel transfer electrode 290 and the third pixel transfer electrode 370 may be disposed by deposition or electroplating. The third light-emitting assembly 400 may also be fixed on the side of the second light-emitting assembly 300 away from the first light-emitting assembly 200 by the metal bonding or the hybrid bonding, so that the second pixel transfer electrode 290 is electrically connected to the third pixel transfer electrode 370, so as to fix the third light-emitting assembly 400 on the second light-emitting assembly 300.

In some embodiments, the common N electrode of the display pixels of the LED display device 1 may be disposed at other positions.

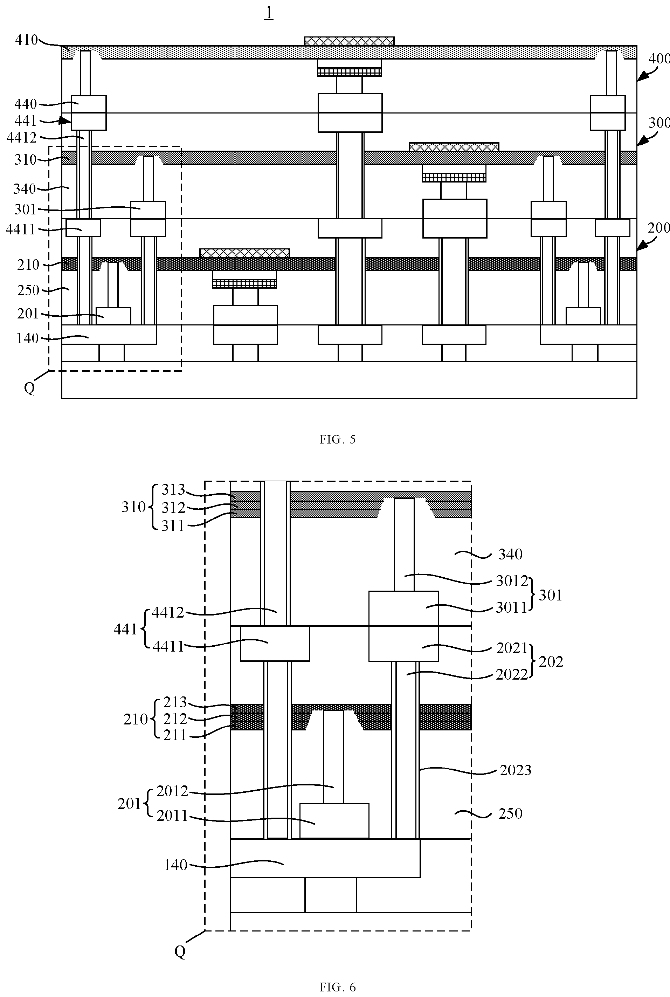

In some embodiments, as shown in FIGS. 5 and 6, the driving substrate 100 may further include a common power supply electrode 140. The first light-emitting assembly 200 may further include a first common extraction electrode 201 and a first common transfer electrode 202. The second light-emitting assembly 300 may further include a second common extraction electrode 301.

In some embodiments, the first light-emitting layer group 210 may include the first semiconductor layer 211, the first active layer 212, and the second semiconductor layer 213 stacked in sequence. The first semiconductor layer 211 is disposed on the side surface of the first active layer 212 facing the driving substrate 100. The specific descriptions of the first semiconductor layer 211, the first active layer 212, and the second semiconductor layer 213 may be found in the previous text, which are not repeated here.

The second light-emitting layer group 310 may also include a third semiconductor layer 311, a second active layer 312, and a fourth semiconductor layer 313 stacked in sequence. The third semiconductor layer 311 is disposed on a side surface of the second active layer 312 facing the first light-emitting assembly 200. Specific descriptions of the third semiconductor layer 311, the second active layer 312, and the fourth semiconductor layer 313 may refer to the first semiconductor layer 211, the first active layer 212, and the second semiconductor layer 213, which are not repeated here.

The first common extraction electrode 201 may pass through the first semiconductor layer 211 and the first active layer 212, and be electrically connected to the second semiconductor layer 213 and/or the second pixel defining electrode 230. The first common transfer electrode 202 passes through the first light-emitting layer group 210. The first common extraction electrode 201 and the first common transfer electrode 202 are electrically connected to the common power supply electrode 140, respectively.

In some embodiments, the common power supply electrode 140 is able to provide the reference voltage to the second semiconductor layer 213 and/or the second pixel defining electrode 230 through the first common extraction electrode 201. Therefore, the first common extraction electrode 201 is able to serve as the common N electrode of the first light-emitting layer group 210, and form the ohmic contact with the second semiconductor layer 213 as the N-type semiconductor, thereby forming a current path among the common power supply electrode 140, the first common extraction electrode 201, the first light-emitting layer group 210, the first pixel defining electrode 220, and the first pixel power supply electrode 110. Therefore, the LED display device 1 can control the first pixel by controlling the common power supply electrode 140 and the first pixel power supply electrode 110.

Similarly, the second common extraction electrode 301 may pass through the third semiconductor layer 311 and the second active layer 312, and be electrically connected to the fourth semiconductor layer 313 and/or the fourth pixel defining electrode 330. The second common extraction electrode 301 may be electrically connected to the common power supply electrode 140 through the first common transfer electrode 202. The second common extraction electrode 301 may also form the ohmic contact with the fourth semiconductor layer 313 and/or the fourth pixel defining electrode 330. Therefore, the current path may be formed among the common power supply electrode 140, the first common transfer electrode 202, the second light-emitting layer group 310, the third pixel defining electrode 320, and the second pixel power supply electrode 120, enabling the LED display device 1 to control the second pixel by controlling the common power supply electrode 140 and the second pixel power supply electrode 120.

The first common extraction electrode 201 may be electrically insulated from the first semiconductor layer 211 and the first active layer 212, and the second common extraction electrode 301 may be electrically insulated from the third semiconductor layer 311 and the second active layer 312. In some embodiments, a gap between the first common extraction electrode 201 and each of the first semiconductor layer 211 and the first active layer 212 may be filled with the first interlayer insulation layer 250, and a gap between the second common extraction electrode 301 and each of the third semiconductor layer 311 and the second active layer 312 may be filled with the third interlayer insulation layer 340, thereby achieving insulation settings.

In some embodiments, the first common transfer electrode 202 may be electrically insulated from the first light-emitting assembly 200, so as to reduce the current leakage from the first common transfer electrode 202 to the first light-emitting assembly 200 during the LED display device 1 being powered and in use.

In some embodiments, as shown in FIG. 6, a first insulation layer 2023 may be disposed between the first common transfer electrode 202 and the first light-emitting assembly 200. The first insulation layer 2023 may be an insulation layer made of silicon dioxide, silicon nitride, aluminum oxide, or other insulation materials.

In some embodiments, the ion bombardment may be applied to a part of the first light-emitting assembly 200 close to the first common transfer electrode 202, so that an insulating area is formed in the first light-emitting assembly 200. In some embodiments, the first common transfer electrode 202 may be electrically insulated from the first light-emitting assembly 200 by other methods, which is not specifically listed here.

In some embodiments, the common power supply electrode 140, the first common extraction electrode 201, the first common transfer electrode 202, and the second common extraction electrode 301 may all be made of the conductive material such as Cu, Cr, Ti, Ni, or Au metal, etc. In some embodiments, the metal bonding or the hybrid bonding may be formed between the first common extraction electrode 201 and the common power supply electrode 140, as well as between the first common transfer electrode 202 and the second common extraction electrode 301. In some embodiments, the metal bonding may be In-In bonding, Au-Au bonding, or Cu-Cu bonding. etc. In some embodiments, the hybrid bonding may be $Cu/SiO_2$-$Cu/SiO_2$ hybrid bonding, Cu/BCB-Cu/BCB hybrid bonding, or Cu/PI-Cu/PI hybrid bonding. The metal bonding or the hybrid bonding can make the connection between the assemblies more secure and ensure the conductivity between the assemblies.

In some embodiments, other fixing methods may also be performed to fix the first common extraction electrode 201 and the common power supply electrode 140, as well as the first common transfer electrode 202 and the second common extraction electrode 301.

In some embodiments, as shown in FIGS. 5 and 6, the first common extraction electrode 201 may include a first common extraction part 2011 and a second common extraction part 2012 connected to each other. In the vertical direction of the stacking direction, a size of the first common extraction part 2011 is greater than that of the second common extraction part 2012. The first common extraction part 2011 is bonded and connected to the common power supply electrode 140, and the second common extraction part 2012 is electrically connected to the second semiconductor layer 213 and/or the second pixel defining electrode 230. This setting can increase a contact area between the first common extraction electrode 201 and the common power supply electrode 140, thereby facilitating the bonding connection between the first common extraction part 2011 and the common power supply electrode 140.

In some embodiments, the second common extraction electrode 301 may also include a third common extraction part 3011 and a fourth common extraction part 3012 connected to each other. In the vertical direction of the stacking direction, a size of the third common extraction part 3011 is greater than that of the fourth common extraction part 3012, and the third common extraction part 3011 is bonded and connected to the first common transfer electrode 202. In some embodiments, the fourth common extraction part 3012 is electrically connected to the fourth semiconductor layer 313 and/or the fourth pixel defining electrode 330.

In some embodiments, the first common transfer electrode 202 may include a first common transfer part 2021 and a second common transfer part 2022 connected to each other. In the vertical direction of the stacking direction, a size of the first common transfer part 2021 is greater than that of the second common transfer part 2022. The third common extraction part 3011 is bonded and connected to the first common transfer part 2021, and the second common transfer part 2022 is electrically connected to the common power supply electrode 140. Similarly, this setting can increase a contact area between the third common extraction part 3011 and the first common transfer electrode 202, thereby facilitating a bonding connection between the third common extraction part 3011 and the first common transfer electrode 202.

In some embodiments, the first common extraction electrode 201 and the fourth common extraction part 3012 may be formed by deposition, which can facilitate the preparation of the LED display device 1.

In some embodiments, the common power supply electrode 140, the first common extraction electrode 201, the first common transfer electrode 202, and the second common extraction electrode 301 may be disposed in a circular shape around periphery of multiple first pixel defining electrodes 220 and periphery of multiple second pixel defining electrodes 230. Through the above setting, it can facilitate a connection of the common power supply electrode 140 to an external reference voltage, facilitate wiring of the LED display device 1, and enable the multiple first pixel defining electrodes 220 and the multiple second pixel defining electrodes 230 to receive a voltage transmitted from the common power supply electrode 140 more evenly, thereby increasing the stability of the LED display device 1.

In some embodiments, as shown in FIGS. 5 to 6, the LED display device 1 includes the third light-emitting assembly 400, and the third light-emitting assembly 400 may include a third common extraction electrode 440. The LED display device 1 further includes a second common transfer electrode 441, and the second common transfer electrode 441 may pass through the second light-emitting assembly 300 and the first light-emitting assembly 200. An end of the second common transfer electrode 441 may be electrically connected to the common power supply electrode 140, and another end of the second common transfer electrode 441 may be electrically connected to the third common extraction electrode 440, so as to transmit the reference voltage provided by the common power supply electrode 140 to the third common extraction electrode 440.

In some embodiments, the second common transfer electrode 441 may include a first transfer electrode part 4411 and a second transfer electrode part 4412. The first transfer electrode part 4411 passes through the first light-emitting assembly 200, and an end of the first transfer electrode part 4411 is electrically connected to the common power supply electrode 140. The second transfer electrode part 4412 passes through the second light-emitting assembly 300. An end of the second transfer electrode part 4412 is bonded and connected to the first transfer electrode part 4411, and another end of the second transfer electrode part 4412 is bonded and connected to the third common extraction electrode 440. Specific structures of the first transfer electrode part 4411 and the second transfer electrode part 4412 may refer to the first common transfer electrode 202, which are not further described here.

An end of the third common extraction electrode 440 that is away from the common power supply electrode 140 passes through the P-type semiconductor and the active layer of the third light-emitting assembly 400 to be in contact with the N-type semiconductor, so that the third common extraction electrode 440 is able to transmit the reference voltage to the N-type semiconductor.

The second common transfer electrode 441 may be electrically insulated from each of the second light-emitting assembly 300 and the first light-emitting assembly 200, and the third common extraction electrode 440 may be electrically insulated from the P-type semiconductor and the active layer of the third light-emitting assembly 400, so as to reduce the current leakage. The specific insulation settings of the second common transfer electrode 441 and the third common extraction electrode 440 may refer to the descriptions of the second common extraction part 2012 and the first common transfer electrode 202 mentioned above, which are not repeated here.

Taking the structure of the LED display device 1 as an example, the following embodiments provides an exemplary description of a preparation process for the LED display device 1.

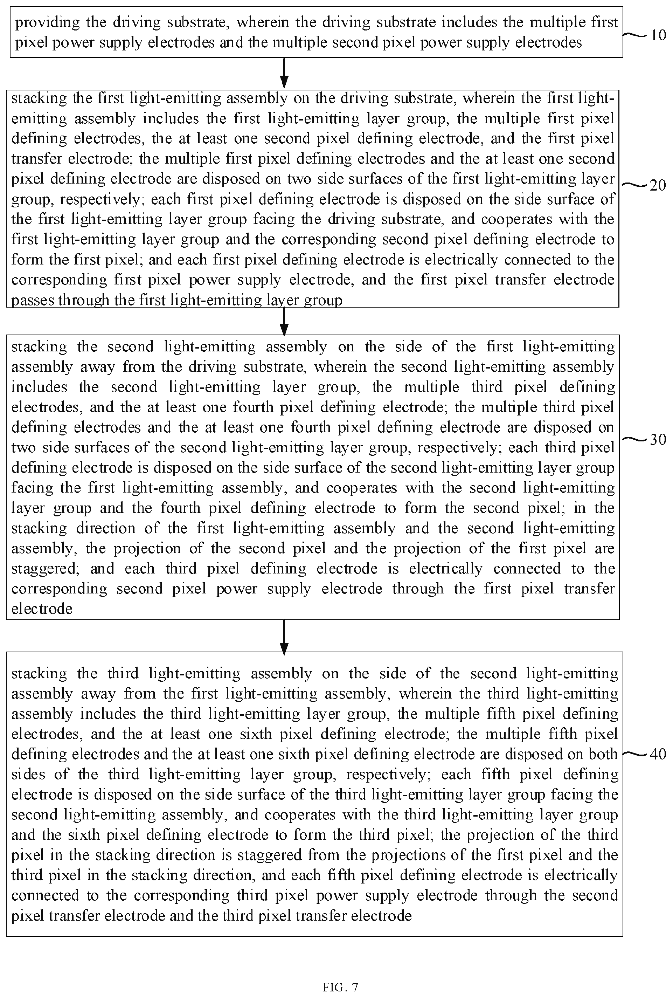

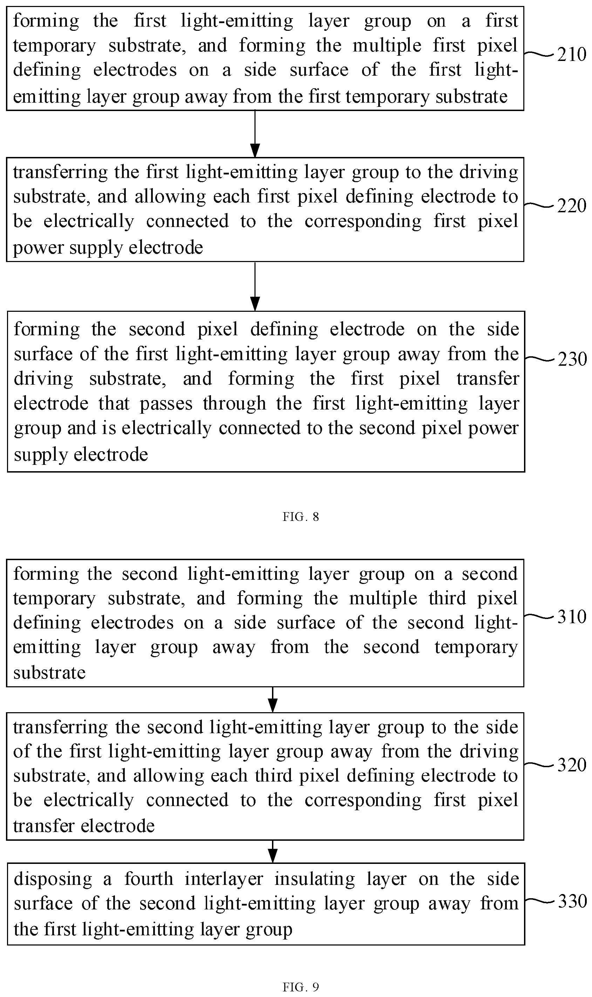

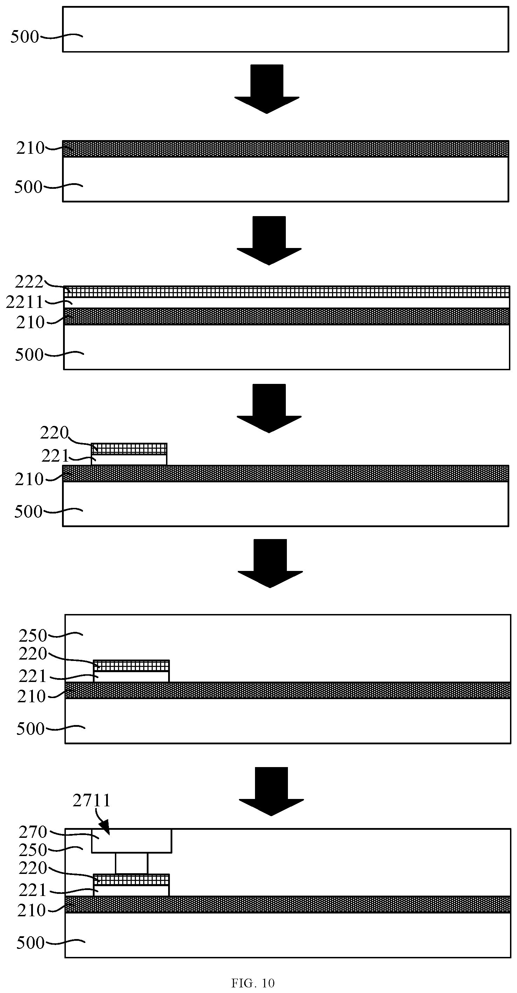

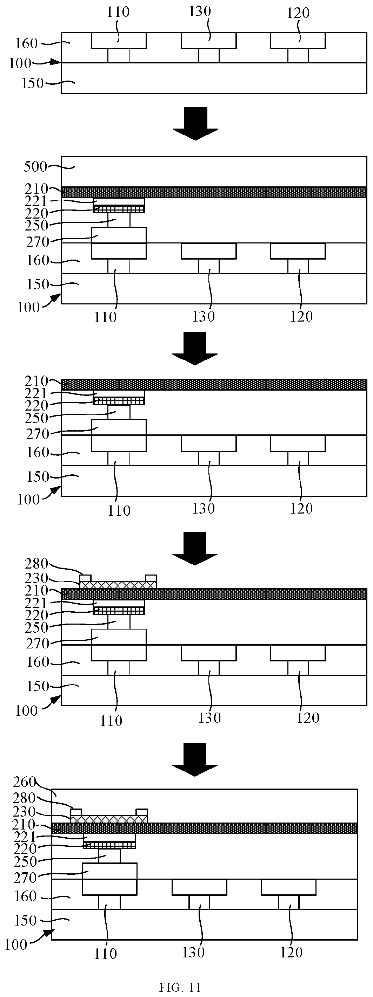

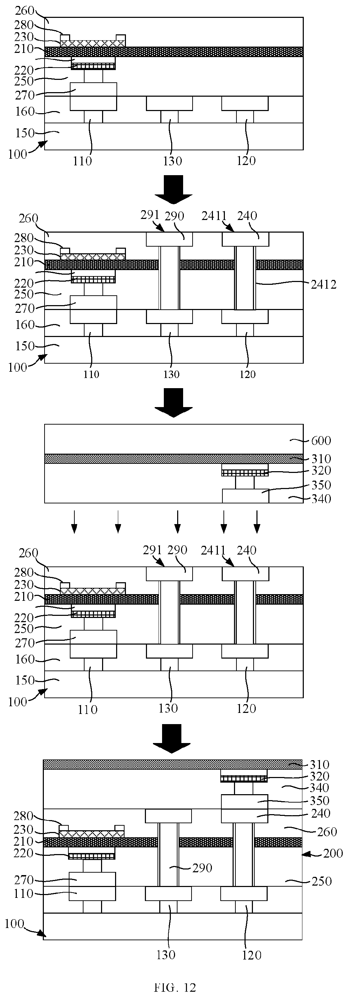

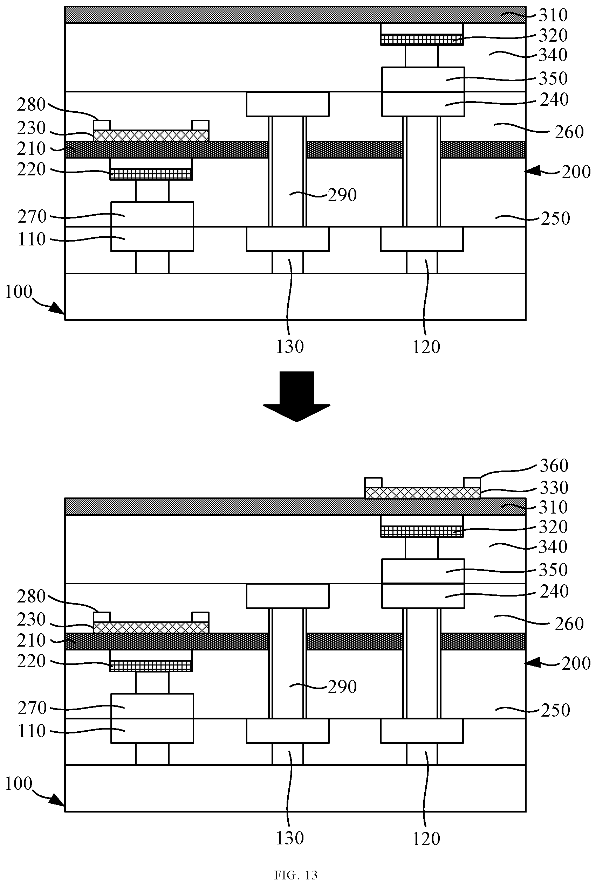

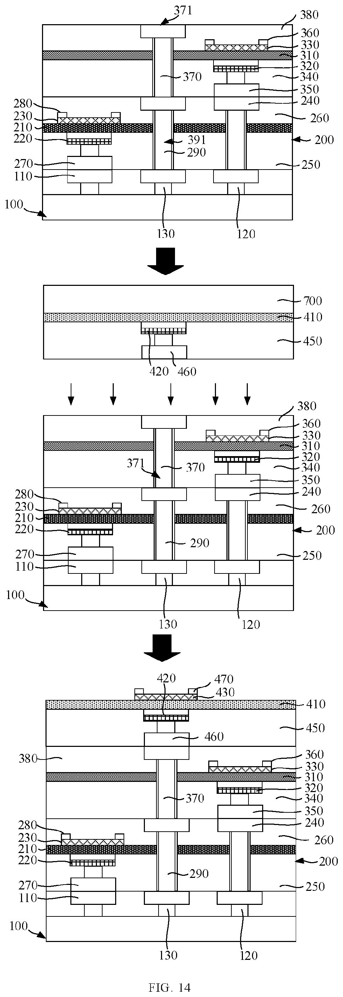

As shown in FIGS. 7 to 19, FIGS. 7 to 9 illustrate preparation process flow of a method for making the LED display device 1 in any one of the above embodiments of the present disclosure, and FIGS. 10 to 14 illustrate the preparation process and component structures involved in the operation flow of FIGS. 7 to 9.

At block S100, the method for making the LED display device may include providing the driving substrate, wherein the driving substrate includes the multiple first pixel power supply electrodes and the multiple second pixel power supply electrodes.

In some embodiments, the multiple first pixel power supply electrodes 110 and the multiple second pixel power supply electrodes 120 may be disposed on a substrate body 150 of the driving substrate 100 in one-to-one correspondence with the first pixels and the second pixels. Then, the gaps between the multiple first pixel power supply electrodes 110 and the multiple second pixel power supply electrodes 120 may be filled with an insulating dielectric layer 160, so as to fix the multiple first pixel power supply electrodes 110 and the multiple second pixel power supply electrodes 120. In some embodiments, chemical mechanical polishing (CMP) may be performed on a surface of the insulating dielectric layer 160 away from the substrate body 150, so as to expose the multiple first pixel power supply electrodes 110 and the multiple second pixel power supply electrodes 120. The surfaces of the multiple first pixel power supply electrodes 110, the surfaces of the multiple second pixel power supply electrodes 120, and the surface of the insulating dielectric layer 160 are planar.

In some embodiments, the LED display device 1 includes multiple third pixels. And accordingly, the driving substrate 100 may include multiple third pixel power supply electrodes 130. The positions of the third pixel power supply electrodes 130 correspond one-to-one with the positions of the third pixels. The multiple first pixel power supply electrodes 110, the multiple second pixel power supply electrodes 120, and the multiple third pixel power supply electrodes 130 are arranged in an array at intervals according to their required positions.

At block S200, the method for making the LED display device may include stacking the first light-emitting assembly on the driving substrate, wherein the first light-emitting assembly includes the first light-emitting layer group, the multiple first pixel defining electrodes, the at least one second pixel defining electrode, and the first pixel transfer electrode; the multiple first pixel defining electrodes and the at least one second pixel defining electrode are disposed on two side surfaces of the first light-emitting layer group, respectively; each first pixel defining electrode is disposed on the side surface of the first light-emitting layer group facing the driving substrate, and cooperates with the first light-emitting layer group and the corresponding second pixel defining electrode to form the first pixel; and each first pixel defining electrode is electrically connected to the corresponding first pixel power supply electrode, and the first pixel transfer electrode passes through the first light-emitting layer group.

In some embodiments, the operation at block S200 may include the following multiple operations at blocks S210 to S230.

At block S210, the operation at block S200 may include forming the first light-emitting layer group on a first temporary substrate, and forming the multiple first pixel defining electrodes on a side surface of the first light-emitting layer group away from the first temporary substrate.

In some embodiments, the operation at block S210 may include operations S211 to S214.

In the operation S211, the operation at block S210 may include providing the first temporary substrate.

The first temporary substrate 500 may be a substrate made of sapphire, silicon, silicon carbide, or gallium nitride, etc. The first temporary substrate 500 may also be a substrate made of a material such as ceramic or glass, etc. The first temporary substrate 500 may also be a printed circuit board (PCB), etc. In the present embodiment, the first temporary substrate 500 is a silicon substrate. The silicon substrate has excellent electrical insulation performance, high thermal conductivity, high adhesion strength, as well as advantages of high strength, shape stability, and easy removal. The silicon substrate can be compatible with semiconductor process device and processes, and the silicon substrate is suitable for high yield display pixel preparation processes.

In the operation S212, the operation at block S210 may include forming the first light-emitting layer group on the first temporary substrate through a growth mode.

The first semiconductor layer 211 of the first light-emitting layer group 210 is away from the first temporary substrate 500, and the second semiconductor layer 213 of the first light-emitting layer group 210 is close to and in contact with the first temporary substrate 500.

In some embodiments, the first light-emitting layer group 210 may be provided, and the first light-emitting layer group 210 may be fixed on the first temporary substrate 500 by a transfer mode or other modes, which is not specifically listed here.

In the operation S213, the operation at block S210 may include forming the first pixel defining electrode on the side surface of the first light-emitting layer group away from the first temporary substrate.

In some embodiments, an annealing process may be performed, so that a transparent electrode layer 2211 and a first metal electrode layer 222 are disposed on the side surface of the first light-emitting layer group 210 away from the first temporary substrate 500. After the annealing process is completed, the transparent electrode layer 2211 may form the ohmic contact with the first light-emitting layer group 210, and the transparent electrode layer 2211 may form the ohmic contact with the first metal electrode layer 222. Then, the transparent electrode layer 2211 and the first metal electrode layer 222 are etched to obtain the transparent electrode layer 221 and the multiple first pixel defining electrodes 220. The positions of the multiple first pixel defining electrodes 220 correspond one-to-one with the positions of the first pixels. In some embodiments, the transparent electrode layer 221 and the first pixel defining electrodes 220 may be formed using a Liftoff mode, which is not limited here.

In the operation S214, the operation at block S210 may include forming the first interlayer insulation layer on the side surface of the first pixel defining electrode away from the first light-emitting layer group.

In some embodiments, the first interlayer insulation layer 250 may be formed on the side surface of the first pixel defining electrode 220 away from the first light-emitting layer group 210. The material of the first interlayer insulation layer 250 may be silicon oxide, silicon nitride, BCB, PI, or other materials, which is not specifically limited here. In some embodiments, a first via 2711 may be defined on an area of the first interlayer insulation layer 250 that corresponds to the first pixel defining electrode 220 through two exposure and etching processes. Then, the first pixel extraction electrode 270 may be further formed in the first via 2711 by deposition, so that the second pixel extraction electrode 350 is electrically connected to the first pixel defining electrode 220. In some embodiments, the first pixel extraction electrode 270 may also be formed by other modes such as magnetron sputtering, electron beam evaporation, or electroplating, etc., which is not specifically limited here.

In some embodiments, the first pixel extraction electrode 270 may be first fixed, so as to establish a conductive connection between the first pixel extraction electrode 270 and the first pixel defining electrode 220. And then the first interlayer insulation layer 250 is further filled and formed, thereby fixing the first pixel extraction electrode 270 and the first pixel defining electrode 220.

In some embodiments, a CMP process may be performed, so that the surfaces of the first interlayer insulation layer 250 and the first pixel extraction electrode 270 away from the first light-emitting layer group 210 are planar and have nanometer level flatness. The first pixel extraction electrode 270 is exposed from the first interlayer insulation layer 250.

In some embodiments, in a case where a thermal expansion coefficient of the first interlayer insulation layer 250 is greater than that of the first pixel extraction electrode 270, the first pixel extraction electrode 270 may be slightly recessed on the surface of the first interlayer insulation layer 250. In some embodiments, the first pixel extraction electrode 270 may be recessed 3 nm below the surface of the first interlayer insulation layer 250. This setting can prepare for subsequent bonding with the driving substrate 100, facilitating expansion of the first pixel extraction electrode 270 during subsequent bonding. In some embodiments, in a case where the thermal expansion coefficient of the first interlayer insulation layer 250 is close to that of the first pixel extraction electrode 270, the first pixel extraction electrode 270 may be flush with the surface of the first interlayer insulation layer 250. This setting can prepare for the subsequent connection bonding with the driving substrate 100.

At block S220, the operation at block S200 may include transferring the first light-emitting layer group to the driving substrate, and allowing each first pixel defining electrode to be electrically connected to the corresponding first pixel power supply electrode.

In some embodiments, the surface of the driving substrate 100 on which the first pixel power supply electrodes 110 are disposed, as well as the surface of the first light-emitting assembly 200 where the first pixel extraction electrode 270 is exposed, may be subjected to plasma activation or chemical treatment. Then, the first light-emitting assembly 200 may be placed upside down on the driving substrate 100, with the first pixel extraction electrode 270 facing the first pixel power supply electrode 110 of the driving substrate 100. The first pixel extraction electrode 270 is accurately aligned with the first pixel power supply electrode 110 by using the combination device. Then, a thermal compression bonding (TCB) process may be further performed, so that the first pixel extraction electrode 270 is heated and bonded to the first pixel power supply electrode 110. In some embodiments, the first pixel extraction electrode 270 may be bonded to the first pixel power supply electrode 110 by using a room temperature bonding process, thereby achieving a high-strength connection between the driving substrate 100 and the first light-emitting layer group 210.

In some embodiments, the first temporary substrate 500 may be removed through a process such as grinding, chemical etching, or laser lift-off (LLO), etc., so as to expose the first light-emitting layer group 210. A thickness of the first light-emitting layer group 210 may be further reduced to a desired thickness through inductively coupled plasma (ICP) etching or CMP grinding.

At block S230, the operation at block S200 may include forming the second pixel defining electrode on the side surface of the first light-emitting layer group away from the driving substrate, and forming the first pixel transfer electrode that passes through the first light-emitting layer group and is electrically connected to the second pixel power supply electrode.

In some embodiments, the second pixel defining electrode 230 may be formed on the side surface of the first light-emitting layer group 210 away from the driving substrate 100 through the mode such as electroplating, deposition, photolithography, etching, etc. The position of the second pixel defining electrode 230 corresponds to the position of the first pixel defining electrode 220. The second pixel defining electrode 230 forms the ohmic contact with the second semiconductor layer 213 of the first light-emitting layer group 210, so as to achieve the conductive connection. The reflectivity of the second pixel defining electrode 230 is less than that of the first pixel defining electrode 220, so that the first light-emitting layer group 210 forms the first resonant cavity. In some embodiments, the number of the second pixel defining electrodes 230 may correspond to the number of the first pixel defining electrodes 220, so as to form the multiple first pixels.

In some embodiments, the first interconnecting electrode 280 may be disposed on the side surface of the second pixel power supply electrode 120 away from the first light-emitting layer group 210, and the first interconnecting electrode 280 is electrically connected to the multiple second pixel defining electrodes 230. The first interconnecting electrode 280 may be grid-shaped and surround the second pixel defining electrode 230, and an end of the first interconnecting electrode 280 is disposed on the edge of the first light-emitting layer group 210. Therefore, the first interconnecting electrode 280 can be connected to an external power source and transmit the reference voltage to the second pixel defining electrode 230, and the second pixel defining electrode 230 can evenly receive the reference voltage provided by the first interconnecting electrode 280.

In some embodiments, the position of the first interconnecting electrode 280 and the positions of other display pixels are disposed in the staggered manner, so that the first interconnecting electrode 280 does not affect the electrode connections of other display pixels.

In some embodiments, the second interlayer insulation layer 260 is disposed and filled on the side surface of the first light-emitting layer group 210 away from the driving substrate 100. The second interlayer insulation layer 260 covers the first light-emitting layer group 210, the second pixel defining electrode 230, and the first interconnecting electrode 280.

In some embodiments, the deep etching is performed on an area of the first light-emitting assembly 200 that corresponds to the second pixel power supply electrode 120, so as to form multiple through holes 2411 on the first light-emitting layer group 210. The second pixel power supply electrode 120 may be exposed in the corresponding through hole 2411.

In some embodiments, in the vertical direction of the stacking direction, the distance from the edge of the part of the through hole 2411 that is disposed in the first light-emitting layer group 210 to the edge of the first pixel defining electrode 220 is greater than or equal to one-fourth of the size of the first pixel defining electrode 220 in the vertical direction. In some embodiments, the distance from the edge of the part of the first pixel transfer electrode 240 that is disposed in the first light-emitting layer group 210 to the edge of the second pixel defining electrode 230 is greater than or equal to one-fourth of the size of the second pixel defining electrode 230 in the vertical dimension. By setting the distance between the through hole 2411 and each of the first pixel defining electrode 220 and the second pixel defining electrode 230 in this way, the current leakage from the first pixel to the first pixel transfer electrode 240 can be avoided, and mutual interference can be avoided.

In some embodiments, the insulating area may be formed on an inner wall of the through hole 2411 of the first light-emitting layer group 210 by the ion bombardment, or the hole wall insulation layer 2412 may be disposed on the hole wall of the through hole 2411. Therefore, the current inside the first light-emitting layer group 210 is not easily leaked from the through hole 2411, and the two are less likely to interfere with each other.

In some embodiments, the first pixel transfer electrode 240 may be disposed in the first through hole 2411 by deposition, electroplating, or other modes, so that the first pixel transfer electrode 240 is electrically connected to the second pixel power supply electrode 120. In some embodiments, the first pixel transfer electrode 240 may also be disposed by using electroplating, electron beam evaporation, magnetron sputtering, or other modes.

In some embodiments, the LED display device 1 includes the multiple third pixels. And accordingly, the deeply etching needs to be performed on the areas of the first light-emitting assembly 200 that corresponds to the multiple third pixel power supply electrodes 130, so as to form multiple second through holes 291 on the first light-emitting layer group 210. Each third pixel power supply electrode 130 is also exposed in the corresponding second through hole 291. In some embodiments, the insulating area may be formed on an inner wall of the second through hole 291 of the first light-emitting layer group 210 by ion bombardment, or the insulation layer may be disposed on a hole wall of the second through hole 291. Therefore, the current inside the first light-emitting layer group 210 is not easily leaked from the second through hole 291, and the two are less likely to interfere with each other.

In some embodiments, the second pixel transfer electrode 290 may also be disposed in the second through hole 291, so that the second pixel transfer electrode 290 is electrically connected to the third pixel power supply electrode 130.

Then, the surface of the second interlayer insulation layer 260 and the surface of the second pixel transfer electrode 290 may be smoothed through ICP etching, grinding, chemical mechanical polishing (CMP) processes, or other modes.

At block S300, the method for making the LED display device may include stacking the second light-emitting assembly on the side of the first light-emitting assembly away from the driving substrate, wherein the second light-emitting assembly includes the second light-emitting layer group, the multiple third pixel defining electrodes, and the at least one fourth pixel defining electrode; the multiple third pixel defining electrodes and the at least one fourth pixel defining electrode are disposed on two side surfaces of the second light-emitting layer group, respectively; each third pixel defining electrode is disposed on the side surface of the second light-emitting layer group facing the first light-emitting assembly, and cooperates with the second light-emitting layer group and the fourth pixel defining electrode to form the second pixel; in the stacking direction of the first light-emitting assembly and the second light-emitting assembly, the projection of the second pixel and the projection of the first pixel are staggered; and each third pixel defining electrode is electrically connected to the corresponding second pixel power supply electrode through the first pixel transfer electrode.

In some embodiments, the operation at block S300 may include the following multiple operations at blocks S310 to S330.

At block S310, the operation at block S300 may include forming the second light-emitting layer group on a second temporary substrate, and forming the multiple third pixel defining electrodes on a side surface of the second light-emitting layer group away from the second temporary substrate.

In some embodiments, the second temporary substrate 600 may be provided. The second temporary substrate 600 may be made of the material such as sapphire, silicon, silicon carbide, ceramic, glass, PCB substrate, etc.

In some embodiments, the second light-emitting layer group 310 may be formed on the first temporary substrate 500 through the growth mode, and the thickness of the second light-emitting layer group 310 may be controlled.

Then, the multiple third pixel defining electrodes 320 may be formed at the positions corresponding to the second pixels by using an annealing-first-then-etching process. Then, the third interlayer insulation layer 340 is disposed on the side surfaces of the second light-emitting layer group 310 and the third pixel defining electrode 320 away from the second temporary substrate 600. The two exposure and etching processes are performed on the areas of the third interlayer insulation layer 340 that correspond to the multiple third pixel defining electrodes 320, so that the second pixel extraction electrode 350 may be disposed. The second pixel extraction electrode 350 is electrically contacted to the third pixel defining electrode 320. Then, the side surface of the third interlayer insulation layer 340 away from the second light-emitting layer group 310 is ground and polished through the chemical mechanical polishing process, so that the side surface of the third interlayer insulation layer 340 away from the second light-emitting layer group 310 is planar.

In some embodiments, the details of the operation at block S310 may refer to the operation at block S210 and are not repeated here or in the figures.

At block S320, the operation at block S300 may include transferring the second light-emitting layer group to the side of the first light-emitting layer group away from the driving substrate, and allowing each third pixel defining electrode to be electrically connected to the corresponding first pixel transfer electrode.

In some embodiments, the surface of the first light-emitting layer group 210 where the first pixel transfer electrode 240 is exposed, as well as the surface of the second light-emitting layer group 310 where the second pixel extraction electrode 350 is exposed, may be subjected to plasma activation or chemical treatment. Then, the second light-emitting layer group 310 may be transferred to the side of the first light-emitting layer group 210 away from the driving substrate 100, with the second pixel extraction electrode 350 facing the first light-emitting layer group 210. The second pixel extraction electrode 350 is accurately aligned with the first pixel transfer electrode 240 by using the combination device.

In some embodiments, the TCB process may be further performed, so that the second pixel extraction electrode 350 is heated and bonded to the first pixel transfer electrode 240. Therefore, the second pixel extraction electrode 350 and the first pixel transfer electrode 240 are bonded and connected to each other, thereby achieving the high-strength connection between the first light-emitting layer group 210 and the second light-emitting layer group 310.

In some embodiments, the second temporary substrate 600 may be removed through the process such as grinding, chemical corrosion, or laser lift-off (LLO), so as to expose the second light-emitting layer group 310. A thickness of first light-emitting layer group 210 can be further reduced, and the thickness of first light-emitting layer group 210 can be controlled.

In some embodiments, the fourth pixel defining electrode 330 may be formed on the side surface of the second light-emitting layer group 310 away from the first light-emitting assembly 200 through electroplating, deposition, or other modes. The position of the fourth pixel defining electrode 330 corresponds to the position of the third pixel defining electrode 320. The second pixel defining electrode 230 is electrically connected to the second semiconductor layer 213 of the first light-emitting layer group 210.

Similarly, the reflectivity of the fourth pixel defining electrode 330 is less than that of the third pixel defining electrode 320, so that the second light-emitting layer group 310 forms the second resonant cavity. In some embodiments, the number of the fourth pixel defining electrodes 330 may correspond to the number of the third pixel defining electrodes 320, so as to form the multiple first pixels.

In some embodiments, the second interconnecting electrode 360 may be disposed on the side surface of the fourth pixel defining electrode 330 away from the second light-emitting layer group 310. The second interconnecting electrode 360 is electrically connected to multiple fourth pixel defining electrodes 330, so that the second interconnecting electrode 360 and the multiple fourth pixel defining electrodes 330 can jointly form the N electrode of the second light-emitting layer group 310. The second interconnecting electrode 360 may be grid-shaped and surround the fourth pixel defining electrode 330, and an end of the second interconnecting electrode 360 is disposed on the edge of the second light-emitting layer group 310. Therefore, the second interconnecting electrode 360 can be connected to the external power source and transmit the reference voltage to the fourth pixel defining electrode 330, and the fourth pixel defining electrode 330 can evenly receive the reference voltage provided by the second interconnecting electrode 360.

In some embodiments, the position of the second interconnecting electrode 360 and the positions of other display pixels are disposed in the staggered manner, so that the second interconnecting electrode 360 does not affect the electrode connections of other display pixels.

In some embodiments, the LED display device 1 further includes a third pixel. The third light-emitting assembly 400 that is configured to form the third pixel needs to be stacked on the side of the second light-emitting layer group 310 away from the first light-emitting layer group 210.

At block S330, the operation at block S300 may include disposing a fourth interlayer insulation layer on the side surface of the second light-emitting layer group away from the first light-emitting layer group.

In some embodiments, a fourth interlayer insulation layer 380 is disposed on the side surface of the second light-emitting layer group 310 away from the first light-emitting layer group 210. The fourth interlayer insulation layer 380 covers the second light-emitting layer group 310, the fourth pixel defining electrode 330, and the second interconnecting electrode 360.

In some embodiments, deep etching may be performed on an area of the second light-emitting layer group 310 that corresponds to the third pixel power supply electrode 130, so that multiple third through holes 371 are defined in the second light-emitting layer group 310. The multiple third through holes 371 correspond to and are communicated with the multiple second through holes 291 formed in the first light-emitting layer group 210, thereby exposing the second pixel transfer electrode 290.

In some embodiments, the insulating area may be formed on the inner wall of the third through hole 371 of the second light-emitting layer group 310 by ion bombardment, or the insulation layer may be disposed on the hole wall of the third through hole 371. Therefore, the current inside the second light-emitting layer group 310 is less likely to leak from the third through hole 371, and the two are less likely to interfere with each other.

In some embodiments, the third pixel transfer electrode 370 may be disposed in the third through hole 371 by deposition, electroplating, or other modes, so that the second pixel transfer electrode 290 is electrically connected to the third pixel transfer electrode 370.

Then, the surface of the fourth interlayer insulation layer 380 and the surface of the third pixel transfer electrode 370 may be smoothed through ICP etching, grinding, the CMP process, or other modes.

At block S400, the method for making the LED display device may include stacking the third light-emitting assembly on the side of the second light-emitting assembly away from the first light-emitting assembly, wherein the third light-emitting assembly includes the third light-emitting layer group, the multiple fifth pixel defining electrodes, and the at least one sixth pixel defining electrode; the multiple fifth pixel defining electrodes and the at least one sixth pixel defining electrode are disposed on both sides of the third light-emitting layer group, respectively; each fifth pixel defining electrode is disposed on the side surface of the third light-emitting layer group facing the second light-emitting assembly, and cooperates with the third light-emitting layer group and the sixth pixel defining electrode to form the third pixel; the projection of the third pixel in the stacking direction is staggered from the projections of the first pixel and the third pixel in the stacking direction, and each fifth pixel defining electrode is electrically connected to the corresponding third pixel power supply electrode through the second pixel transfer electrode and the third pixel transfer electrode.

In some embodiments, the third light-emitting assembly 400 may be provided, and the preparation process of the third light-emitting assembly 400 may include the following multiple operations S410 to S430.

In the operation S410, the operation at block S400 may include forming the third light-emitting layer group on a third temporary substrate, and forming the multiple fifth pixel defining electrodes on the side surface of the third light-emitting layer group away from the third temporary substrate.

Similarly, a third temporary substrate 700 is provided. The third temporary substrate 700 may be made of the material such as sapphire, silicon, silicon carbide, ceramic, glass. In some embodiments, the third temporary substrate 700 may be the PCB substrate, etc. In some embodiments, the third light-emitting layer group 410 may be formed on the first temporary substrate 500 through the growth mode, and the thickness of the third light-emitting layer group 410 may be controlled. Then, the multiple fifth pixel defining electrodes 420 are disposed at the positions corresponding to the third pixels by using the annealing-first-then-etching process.

In some embodiments, the fifth interlayer insulation layer 450 is disposed on the side surface of the third light-emitting layer group 410 and the fifth pixel defining electrode 420 away from the third temporary substrate 700. The two exposure and etching processes are performed on the areas of the fifth interlayer insulation layer 450 corresponding to the multiple fifth pixel defining electrodes 420, so that the third pixel extraction electrode 460 are disposed and the third pixel extraction electrode 460 is electrically contacted to the multiple fifth pixel defining electrode 420.

Then, the surface of the third interlayer insulation layer 340 away from the second light-emitting layer group 310 is polished and smoothed through the CMP process.

In some embodiments, the details of the operation at block S410 may refer to the operation at block S210 and are not repeated here.

In the operation S420, the operation at block S400 may include transferring the third light-emitting layer group to the side of the second light-emitting layer group away from the first light-emitting layer group, and allowing each fifth pixel defining electrode to be electrically connected to the corresponding third pixel transfer electrode.

In some embodiments, the surface of the second light-emitting layer group 310 where the third pixel transfer electrode 370 is exposed, as well as the surface of the third light-emitting layer group 410 where the third pixel extraction electrode 460 is exposed, may be subjected to plasma activation or chemical treatment. Then, the third light-emitting layer group 410 may be transferred to the side of the second light-emitting layer group 310 away from the first light-emitting layer group 210, with the third pixel extraction electrode 460 facing the second light-emitting layer group 310. The third pixel extraction electrode 460 may be accurately aligned with the third pixel transfer electrode 370 by using the combination device.

In some embodiments, the TCB process may be performed, so that the third pixel extraction electrode 460 is heated and bonded to the third pixel transfer electrode 370. The third pixel extraction electrode 460 and the third pixel transfer electrode 370 are bonded and connected to each other, thereby achieving the high-strength connection between the second light-emitting layer group 310 and the third light-emitting layer group 410.

In some embodiments, the third temporary substrate 700 may be removed through the process such as grinding, chemical corrosion, or laser lift-off (LLO), so as to expose the third light-emitting layer group 410. The thickness of the third light-emitting layer group 410 may be further reduced, and the thickness of the third light-emitting layer group 410 may be controlled.

In the operation S430, the operation at block S400 may include forming the sixth pixel defining electrode on the side surface of the third light-emitting layer group away from the second light-emitting assembly.

In some embodiments, the sixth pixel defining electrode 430 may be formed on the side surface of the first light-emitting layer group 210 away from the driving substrate 100 through electroplating, deposition, or other modes. The position of the sixth pixel defining electrode 430 corresponds to the position of the fifth pixel defining electrode 420. The sixth pixel defining electrode 430 is electrically connected to the second semiconductor layer 213 of the third light-emitting layer group 410, so as to form the multiple third pixels.

The reflectivity of the sixth pixel defining electrode 430 is less than that of the fifth pixel defining electrode 420, so that the third light-emitting layer group 410 forms a resonant cavity. In some embodiments, the number of the sixth pixel defining electrodes 430 may correspond to the number of the fifth pixel defining electrodes 420.

In some embodiments, a third interconnecting electrode 470 may be disposed on the side surface of the sixth pixel defining electrode 430 away from the third light-emitting layer group 410, and the third interconnecting electrode 470 may also be electrically connected to the multiple sixth pixel defining electrodes 430. The third interconnecting electrode 470 may be grid-shaped and surround the sixth pixel defining electrode 430, and an end of the third interconnecting electrode 470 is disposed on the edge of the third light-emitting layer group 410, so that the third interconnecting electrode 470 can be connected to the external power source and transmit the reference voltage to the third pixel defining electrode 320.

In some embodiments, the position of the third interconnecting electrode 470 is staggered from the positions of other display pixels, so that the third interconnecting electrode 470 does not affect the electrode connections of other display pixels.

By the above method, the LED display device 1 with three types of pixels can be obtained. The light emitted by the first pixel, the second pixel, and the third pixel have different wavelengths, so that the first pixel, the second pixel, and the third pixel can emit light of different colors.

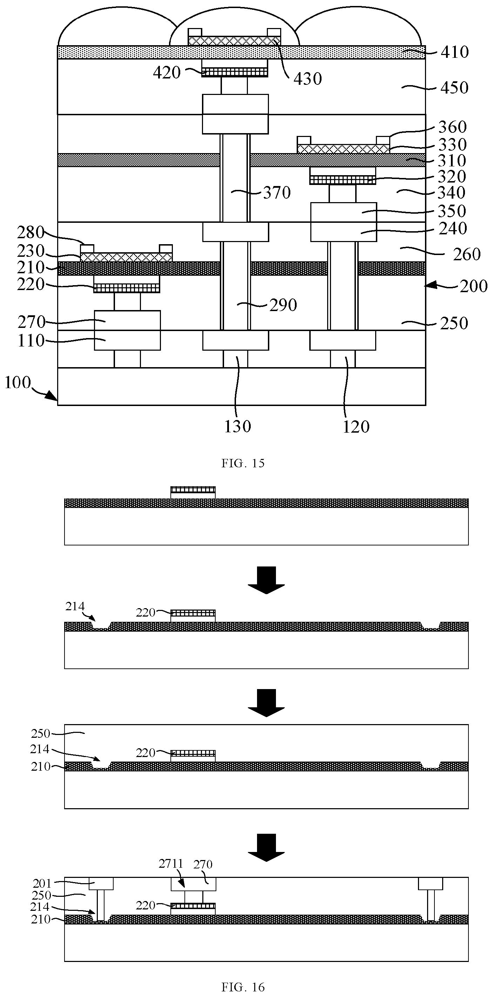

In some embodiments, after preparing the LED display device 1, additional process or operation may be added according to the requirements. In some embodiments, as shown in FIG. 15, multiple microlenses may be disposed to the LED display device 1. The multiple microlenses may be disposed on a side opposite to the driving substrate 100 and disposed on positions corresponding to the pixels, so as to form a microlens array and further regulate a light type of the emitted light.

In some embodiments, the common N electrode of the LED display device 1 may be disposed by other modes.

In some embodiments, as shown in FIGS. 16 to 19, the common N electrode may be disposed on periphery of the LED display device 1. The common N electrode is connected to the first light-emitting layer group 210, the second light-emitting layer group 310, and the third light-emitting layer group 410. The specific operations may be described as follows.

In some embodiments, the driving substrate 100 is provided. The driving substrate 100 may further include the common power supply electrode 140.

In some embodiments, the first light-emitting assembly 200 and the second light-emitting assembly 300 are provided. The first light-emitting assembly 200 further includes the first common extraction electrode 201, and the first light-emitting assembly 200 further includes the second common extraction electrode 301. The first light-emitting layer group 210 includes the first semiconductor layer 211, the first active layer 212, and the second semiconductor layer 213 stacked in sequence. The first semiconductor layer 211 is disposed on the side surface of the first active layer 212 facing the driving substrate 100. The second light-emitting layer group 310 includes the third semiconductor layer 311, the second active layer 312, and the fourth semiconductor layer 313 stacked in sequence. The third semiconductor layer 311 is disposed on the side surface of the second active layer 312 facing the first light-emitting assembly 200.

The first common extraction electrode 201 passes through the first semiconductor layer 211 and the first active layer 212, and the first common extraction electrode 201 is electrically connected to the second semiconductor layer 213 and/or the second pixel defining electrode 230. The second common extraction electrode 301 passes through the third semiconductor layer 311 and the second active layer 312, and the second common extraction electrode 301 is electrically connected to the fourth semiconductor layer 313 and/or the fourth pixel defining electrode 330.

In some embodiments, as shown in FIG. 15, the process of preparing the second light-emitting assembly 300 may refer to the operation at block S210. After the operation S213, the following operation S510 may be included.

In the operation S510, the first common extraction electrode is disposed on the side surface of the first light-emitting layer group away from the first temporary substrate.

In some embodiments, after forming the multiple first pixel defining electrodes 220, etching treatment is performed at the position corresponding to the first common extraction electrode 201, penetrating through both the first semiconductor layer 211 and the first active layer 212, so that a first recess area 214 is formed. The first recess area 214 may be ring-shaped and formed on the side surface of the first semiconductor layer 211 away from the active layer, and surrounds the area of each first pixel electrode. Moreover, a depth of the first recess area 214 may be less than the thickness of the first light-emitting layer group 210, and the second semiconductor layer 213 may be exposed from the first recess area 214.

In some embodiments, the first interlayer insulation layer 250 may be disposed. Drilling, deep etching, or other treatments may be performed on the areas of the first interlayer insulation layer 250 that correspond to the first recess area 214 and the multiple first pixel defining electrodes 220. Therefore, the first via hole 2711 are defined to expose the multiple first pixel defining electrodes 220, and the hole corresponding to the first common extraction electrode 201 is defined. Then, the first common extraction electrode 201 and the multiple first pixel extraction electrodes 270 electrically connected to the second semiconductor layer 213 may be disposed by deposition or electroplating.

In some embodiments, the first common extraction electrode 201 may be first disposed in the first recess area 214, so that the first common extraction electrode 201 is electrically connected to the second semiconductor layer 213 and/or the second pixel defining electrode 230. And then, the first interlayer insulation layer 250 is disposed.

Then, the side surface of the third interlayer insulation layer 340 away from the second light-emitting layer group 310 is ground and polished by the CMP process, so that the side surface of the third interlayer insulation layer 340 away from the second light-emitting layer group 310 is planar.

During preparing the second light-emitting assembly 300, the second common extraction electrode 301 is disposed on the side surface of the second light-emitting layer group 310 away from the second temporary substrate 600. This operation may refer to the operation S510, which is not repeated here.

During preparing the third light-emitting assembly 400, the third common extraction electrode 440 may also be disposed on the side surface of the third light-emitting layer group 410 away from the third temporary substrate 700. This operation may also refer to the operation S510, which is not repeated here.

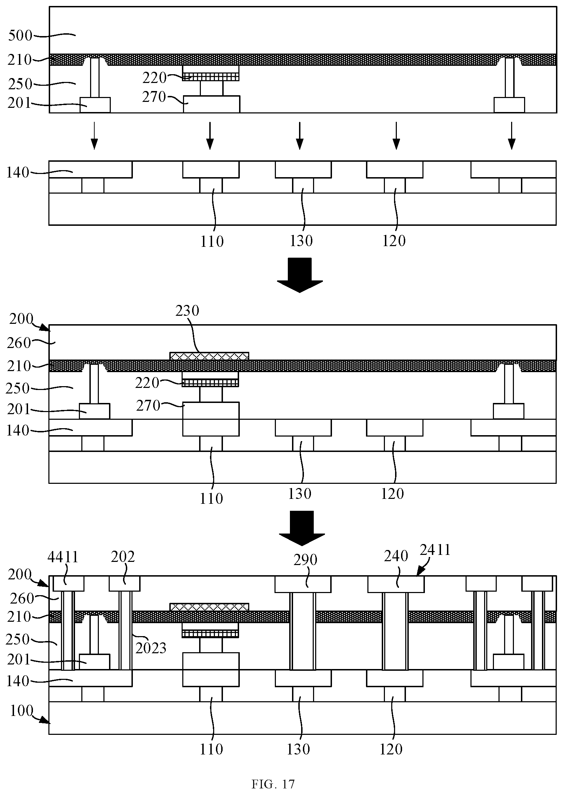

In some embodiments, as shown in FIG. 17, the operation of stacking the first light-emitting assembly 200 on the driving substrate 100 further includes an operation S511.

In the operation S511, the first common extraction electrode is electrically connected to the common power supply electrode, to form the first common transfer electrode. The first common transfer electrode passes through the first light-emitting layer group and is electrically connected to the common power supply electrode.

In some embodiments, during transferring the first light-emitting assembly 200 on the driving substrate 100, the first common extraction electrode 201 corresponds to the common power supply electrode 140, and the first pixel defining electrode 220 corresponds to the first pixel power supply electrode 110. Then, the TCB process may be further performed, so that the first pixel extraction electrode 270 is heated and bonded (or bonded at a room temperature) to the first pixel power supply electrode 110, and the first common extraction electrode 201 is heated and bonded (or bonded at the room temperature) to the common power supply electrode 140. Therefore, the first pixel extraction electrode 270 and the first pixel power supply electrode 110 are bonded and connected to each other, and the first common extraction electrode 201 and the common power supply electrode 140 are bonded and connected to each other.

In some embodiments, the first temporary substrate 500 may be removed through the process such as grinding, chemical corrosion, or laser lift-off (LLO), so as to expose the first light-emitting layer group 210. The thickness of the first light-emitting layer group 210 may be further reduced to the desired thickness.

In some embodiments, the second pixel defining electrode 230 and the second interlayer insulation layer 260 may be formed. In this case, the second pixel defining electrode 230 is only used as a reflection mirror configured to form the resonant cavity, without electrical connection. Afterwards, deep etching may be performed on areas of the first light-emitting layer group 210 that correspond to the second common extraction electrode 301 and the multiple second pixel power supply electrodes 120, so that the first light-emitting layer group 210 defines the multiple holes corresponding to the second common extraction electrode 301 and the multiple through holes 2411. The hole corresponding to the second common extraction electrode 301 passes through the first light-emitting layer group 210, so that the common power supply electrode 140 is exposed. The second pixel power supply electrode 120 is exposed from the through hole 2411.

In some embodiments, a first insulation layer 2023 may be disposed on an inner wall of an annular hole, or the insulating area is formed on the inner wall of the annular hole by ion bombardment. In some embodiments, the first common transfer electrode 202 may be disposed in the annular hole and the first pixel transfer electrode 240 may be disposed in the through hole 2411 through electroplating, deposition, or other modes. Therefore, the first common transfer electrode 202 is electrically connected to the common power supply electrode 140, and the first pixel transfer electrode 240 is electrically connected to the second pixel power supply electrode 120.

In some embodiments, the LED display device 1 includes the third light-emitting assembly 400, and the third light-emitting assembly 400 may include the third common extraction electrode 440. In this case, deep etching may be performed on the areas of the first light-emitting assembly 200 that correspond to the third common extraction electrode 440 and the third pixel, so as to expose the common power supply electrode 140 and the third pixel power supply electrode 130, respectively. The corresponding insulation layer may be disposed on the inner wall of each of all the holes. In some embodiments, the first transfer electrode part 4411 and the second pixel transfer electrode 290 are disposed in the corresponding hole through electroplating, deposition, or other modes, so that the first transfer electrode part 4411 is electrically connected to the common power supply electrode 140, and the second pixel transfer electrode 290 is electrically connected to the third pixel power supply electrode 130.

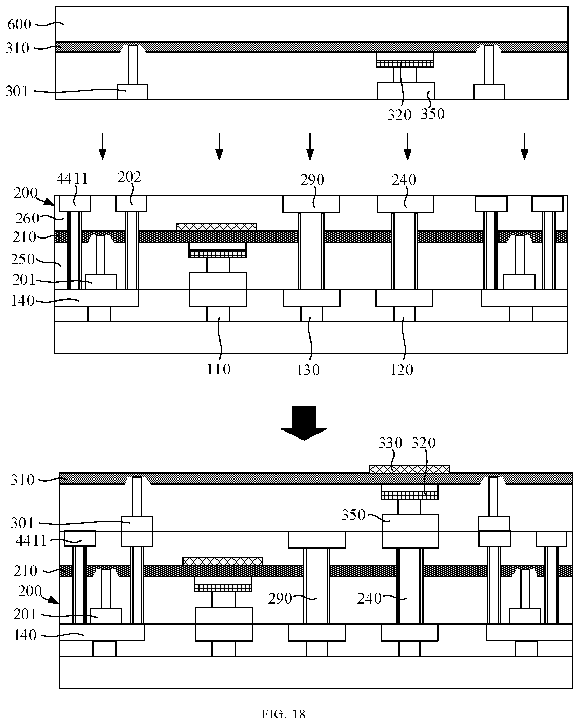

In some embodiments, as shown in FIG. 18, the operation of stacking the second light-emitting assembly 300 on the side of the first light-emitting assembly 200 away from the driving substrate 100 includes an operation S521.

In the operation S521, the second common extraction electrode is electrically connected to the first common transfer electrode.

In some embodiments, the second light-emitting layer group 310 is transferred on the side of the first light-emitting layer group 210 away from the driving substrate 100 in such a way that the second common extraction electrode 301 is aligned with the first common transfer electrode 202 and the third pixel defining electrode 320 corresponds to the first pixel transfer electrode 240. Similarly, the TCB process may be further performed, so that the third pixel defining electrode 320 is bonded and electrically connected to the first pixel transfer electrode 240, and the second common extraction electrode 301 is bonded and electrically connected to the first common transfer electrode 202.

In some embodiments, the second temporary substrate 600 may be removed through the process such as grinding, chemical corrosion, or laser lift-off (LLO), so as to expose the second light-emitting layer group 310. The thickness of the second light-emitting layer group 310 may be further reduced to the desired thickness.

In some embodiments, the LED display device 1 includes the third light-emitting assembly 400. The deep etching may be performed on the areas of the second light-emitting assembly 300 that correspond to the third common extraction electrode 440 and the third pixel, so that the holes are defined to expose the first transfer electrode part 4411 and the second pixel transfer electrode 290. The corresponding insulation layer may be disposed on the inner wall of each hole. Subsequently, the second transfer electrode part 4412 and third pixel transfer electrode 370 are respectively disposed in the corresponding hole through electroplating, deposition, or other modes, so that the second transfer electrode part 4412 is electrically connected to the first transfer electrode part 4411, and the third pixel transfer electrode 370 is electrically connected to the second pixel transfer electrode 290.

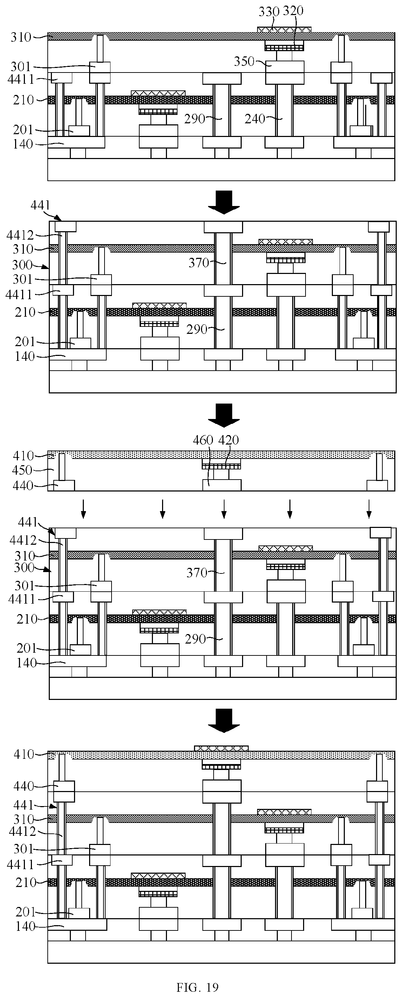

In some embodiments, the specific operations for bonding and connecting the third common extraction electrode 440 of the third light-emitting assembly 400 to the second transfer electrode part 4412, and the specific operations for bonding and connecting the third pixel transfer electrode 370 to the fifth pixel defining electrode 420, may refer to the operation at block S400, the operation S521, and FIG. 19, which are not repeated here.

By the above method, the common N electrode of each light-emitting assembly may be disposed on the edge of each light-emitting assembly, so as to ensure a more uniform and planar light-emitting surface of each light-emitting assembly. This can improve the light extraction efficiency of the LED display device 1, reduce the preparation difficulty of the LED display device 1, and improve the yield of the LED display device 1.

Similarly, in some embodiments, a functional layer may be disposed in the LED display device 1 and disposed on a side away from the driving substrate 100, such as disposing the microlens to each pixel electrode.

In summary, in the present disclosure, the first light-emitting assembly 200 and the second light-emitting assembly 300 are stacked on the driving substrate 100, so that the first pixel and the second pixel are disposed on different planes, thereby reducing the preparation difficulty associated with the high-density pixel point integrated array in the same plane. This can reduce the difficulty of preparing the LED display device 1 while ensuring the density of the display pixel points of the LED display device 1. Moreover, this can also reduce the risk of damaging the LED display device 1 that is caused by excessive etching in the same planar component, thereby improving the yield of LED chips.

The above descriptions are only some embodiments of the present disclosure, and are not intended to limit the protection scope of the present disclosure. Any equivalent structure or equivalent flow transformation made by using the contents and the accompanying drawings of the present disclosure, or directly or indirectly applied to other related technical fields, is included in the protection scope of the present disclosure.

## Claims

1. An LED display device, **characterized by** comprising:

    a driving substrate, comprising a plurality of first pixel power supply electrodes and a plurality of second pixel power supply electrodes;
    a first light-emitting assembly, comprising a first light-emitting layer group, a plurality of first pixel defining electrodes, at least one second pixel defining electrode, and a plurality of first pixel transfer electrodes; wherein the plurality of first pixel defining electrodes and the at least one second pixel defining electrode are disposed on two side surfaces of the first light-emitting layer group, respectively; each first pixel defining electrode is disposed on a side surface of the first light-emitting layer group facing the driving substrate and configured to cooperate with the first light-emitting layer group and the second pixel defining electrode to form a first pixel; and each first pixel defining electrode is electrically connected to a corresponding first pixel power supply electrode, and the plurality of first pixel transfer electrodes pass through the first light-emitting layer group; and

a second light-emitting assembly, stacked on a side of the first light-emitting assembly away from the driving substrate; wherein the second light-emitting assembly comprises a second light-emitting layer group, a plurality of third pixel defining electrodes, and at least one fourth pixel defining electrode; the plurality of third pixel defining electrodes and the at least one fourth pixel defining electrode are disposed on two side surfaces of the second light-emitting layer group, respectively; each third pixel defining electrode is disposed on a side surface of the second light-emitting layer group facing the first light-emitting assembly and configured to cooperate with the second light-emitting layer group and the fourth pixel defining electrode to form a second pixel; in a stacking direction of the first light-emitting assembly and the second light-emitting assembly, a projection of the second pixel is staggered from a projection of the first pixel; and each third pixel defining electrode is electrically connected to a corresponding second pixel power supply electrode through a corresponding first pixel transfer electrode.

2. The LED display device according to claim 1, wherein in a vertical direction of the stacking direction, a distance from an edge of a part of each first pixel transfer electrode disposed in the first light-emitting layer group to an edge of a corresponding first pixel defining electrode is greater than or equal to one-fourth of a size of the corresponding first pixel defining electrode along the vertical direction, and/or in the vertical direction of the stacking direction, a distance from the edge of the part of each first pixel transfer electrode disposed in the first light-emitting layer group to an edge of the second pixel defining electrode is greater than or equal to one-fourth of a size of the second pixel defining electrode along the vertical direction.

3. The LED display device according to claim 1, wherein the first light-emitting layer group is provided with an insulating area that is formed by ion bombardment on periphery of the plurality of first pixel transfer electrodes; or

the first light-emitting layer group comprises a first semiconductor layer, a first active layer, and a second semiconductor layer stacked in sequence, and the first semiconductor layer is disposed on a side surface of the first active layer facing the driving substrate; a thickness and resistivity of the first semiconductor layer are set, so that during normal operation of the LED display device, a lateral current diffusion length of the first semiconductor layer satisfies:

$$Ls \leq 1/2 \times D1,$$

wherein Ls is the lateral current diffusion length of the first semiconductor layer, and D1 is a shortest distance between the edge of the part of each first pixel transfer electrode disposed in the first light-emitting layer group and the edge of an adjacent first pixel defining electrode; or the first light-emitting layer group defines a through hole, each first pixel transfer electrode passes through the through hole, and a hole wall of the through hole is provided with a hole wall insulation layer.

4. The LED display device according to claim 1, wherein the first light-emitting assembly is fixed on the driving substrate by metal bonding or hybrid bonding, and the second light-emitting assembly is fixed on the side of the first light-emitting assembly away from the driving substrate by the metal bonding or the hybrid bonding.

5. The LED display device according to claim 4, wherein the first light-emitting assembly further comprises a first interlayer insulation layer, a second interlayer insulation layer, and a first pixel extraction electrode; the first interlayer insulation layer covers a side surface of the first light-emitting layer group facing the driving substrate and the plurality of first pixel defining electrodes; an end of the first pixel extraction electrode is electrically connected to a corresponding first pixel defining electrode, and another end of the first pixel extraction electrode is exposed from a side surface of the first interlayer insulation layer facing the driving substrate; the first pixel extraction electrode is bonded to a corresponding first pixel power supply electrode, and the second interlayer insulation layer covers a side surface of the first light-emitting layer group away from the driving substrate and the second pixel defining electrode; and the plurality of first pixel transfer electrodes pass through the first interlayer insulation layer and the second interlayer insulation layer; and the second light-emitting assembly further comprises a third interlayer insulation layer and a second pixel extraction electrode, and the third interlayer insulation layer covers a side surface of the second light-emitting layer group facing the first light-emitting layer group and the plurality of third pixel defining electrodes; an end of the second pixel extraction electrode is electrically connected to a corresponding third pixel defining electrode, and another end of the second pixel extraction electrode is exposed from a side surface of the third interlayer insulation layer facing the first light-emitting layer group; and the second pixel extraction electrode and a corresponding first pixel transfer electrode are bonded to each other.

6. The LED display device according to claim 5, wherein each first pixel power supply electrode comprises a first pixel power supply part and a second pixel power supply part connected to each other, and the first pixel extraction electrode comprises a first pixel extraction part and a second pixel extraction part connected to each other; in a vertical direction of the stacking direction, a size of the first pixel power supply part is greater than that of the second pixel power supply part, and a size of the first pixel extraction part is greater than that of the second pixel extraction part; and the first pixel power supply part and the first pixel extraction part are bonded to each other, and the second pixel power supply part is electrically connected to the corresponding first pixel defining electrode; and
the second pixel extraction electrode comprises a third pixel extraction part and a fourth pixel extraction part connected to each other, and each first pixel transfer electrode comprises a first pixel transfer part and a second pixel transfer part connected to each other; in the vertical direction of the stacking direction, a size of the first pixel transfer part is greater than that of the second pixel transfer part, and a size of the third pixel extraction part is greater than that of the fourth pixel extraction part; and the first pixel transfer part and the third pixel extraction part are bonded to each other, and the fourth pixel extraction part is electrically connected to the corresponding third pixel defining electrode.

7. The LED display device according to claim 6, wherein conductive connections are formed by deposition between the second pixel extraction part and the corresponding first pixel defining electrode, between the fourth pixel extraction part and the corresponding third pixel defining electrode, and between the second pixel transfer part and the corresponding second pixel power supply electrode, respectively.

8. The LED display device according to claim 1, wherein the at least one second pixel defining electrode comprises a plurality of second pixel defining electrodes, the number of the second pixel defining electrodes corresponds to the number of the first pixel defining electrodes, and the first light-emitting assembly further comprises a first interconnecting electrode that is electrically connected to the plurality of second pixel defining electrodes; and/or
the at least one fourth pixel defining electrode comprises a plurality of fourth pixel defining electrodes, the number of the fourth pixel defining electrodes corresponds to the number of the third pixel defining electrodes, and the second light-emitting assembly further comprises a second interconnecting electrode that is electrically connected to the plurality of fourth pixel defining electrodes.

9. The LED display device according to claim 8, wherein reflectivity of each second pixel defining electrode is less than that of each first pixel defining electrode, a thickness of the first light-emitting layer group is controlled to form a first resonant cavity emitting light from a side of a corresponding second pixel defining electrode, and the first interconnecting electrode is grid-shaped and covers a part of the corresponding second pixel defining electrode along an edge of the corresponding second pixel defining electrode; and/or
reflectivity of each fourth pixel defining electrode is less than that of each third pixel defining electrode, a thickness of the second light-emitting layer group is controlled to form a second resonant cavity emitting light from a side of a corresponding fourth pixel defining electrode, and the second interconnecting electrode is grid-shaped and covers a part of the corresponding fourth pixel defining electrode along an edge of the corresponding fourth pixel defining electrode.

10. The LED display device according to claim 1, wherein the driving substrate further comprises a common power supply electrode, the first light-emitting assembly further comprises a first common extraction electrode and a first common transfer electrode, and the second light-emitting assembly further comprises a second common extraction electrode;

the first light-emitting layer group comprises a first semiconductor layer, a first active layer, and a second semiconductor layer stacked in sequence, and the first semiconductor layer is disposed on a side surface of the first active layer facing the driving substrate; and the second light-emitting layer group comprises a third semiconductor layer, a second active layer, and a fourth semiconductor layer stacked in sequence, and the third semiconductor layer is disposed on a side surface of the second active layer facing the first light-emitting assembly; and the first common extraction electrode passes through the first semiconductor layer and the first active layer, and is electrically connected to the second semiconductor layer and/or the second pixel defining electrode; the first common transfer electrode passes through the first light-emitting layer group, and the first common extraction electrode and the first common transfer electrode are electrically connected to the common power supply electrode, respectively; the second common extraction electrode passes through the third semiconductor layer and the second active layer, and is electrically connected to the fourth semiconductor layer and/or the fourth pixel defining electrode, respectively; and the second common extraction electrode is electrically connected to the common power supply electrode through the first common transfer electrode.

11. The LED display device according to claim 10, wherein the first common extraction electrode comprises a first common extraction part and a second common extraction part connected to each other; in a vertical direction of the stacking direction, a size of the first common extraction part is greater than that of the second common extraction part; and the first common extraction part is bonded and connected to the common power supply electrode, and the second common extraction part is electrically connected to the second semiconductor layer and/or the second pixel defining electrode; and
the second common extraction electrode comprises a third common extraction part and a fourth common extraction part connected to each other; in the vertical direction of the stacking direction, a size of the third common extraction part is greater than that of the fourth common extraction part; and the third common extraction part is bonded and connected to the first common transfer electrode, and the fourth common extraction part is electrically connected to the fourth semiconductor layer and/or the fourth pixel defining electrode.

12. The LED display device according to claim 11, wherein the first common transfer electrode comprises a first common transfer part and a second common transfer part connected to each other; in the vertical direction of the stacking direction, a size of the first common transfer part is greater than that of the second common transfer part; and the third common extraction part is bonded and connected to the first common transfer part, and the second common transfer part is electrically connected to the common power supply electrode.

13. The LED display device according to claim 10, wherein the common power supply electrode, the first common extraction electrode, the first common transfer electrode, and the second common extraction electrode are disposed in a circular shape around periphery of the plurality of first pixel defining electrodes and the second pixel defining electrodes.

14. The LED display device according to claim 1, wherein a wavelength of output light from the first light-emitting assembly is greater than that of output light from the second light-emitting assembly.

15. The LED display device according to claim 1, wherein the driving substrate further comprises a plurality of third pixel power supply electrodes, the first light-emitting assembly further comprises a second pixel transfer electrode passing through the first light-emitting layer group, the second light-emitting assembly further comprises a third pixel transfer electrode passing through the second light-emitting layer group, and the third pixel transfer electrode is aligned with and connected to the second pixel transfer electrode; and
the LED display device further comprises a third light-emitting assembly, and the third light-emitting assembly is stacked on a side of the second light-emitting assembly away from the first light-emitting assembly; the third light-emitting assembly comprises a third light-emitting layer group, a plurality of fifth pixel defining electrodes, and at least one sixth pixel defining electrode; the plurality of fifth pixel defining electrodes and the at least one sixth pixel defining electrode are disposed on two side surfaces of the third light-emitting layer group, respectively; the fifth pixel defining electrode is disposed on a side surface of the third light-emitting layer group facing the second light-emitting assembly, and configured to cooperate with the third light-emitting layer group and the sixth pixel defining electrode to form a third pixel; in the stacking direction, a projection of the third pixel is staggered from that of the first pixel and that of the third pixel, respectively; and each fifth pixel defining electrode is electrically connected to a corresponding third pixel power supply electrode through the second pixel transfer electrode and the third pixel transfer electrode.

16. The LED display device according to claim 15, wherein the third light-emitting assembly is fixed on the side of the second light-emitting assembly away from the first light-emitting assembly by metal bonding or hybrid bonding, a wavelength of output light from the first light-emitting assembly is greater than that of output light from the second light-emitting assembly, and a wavelength of output light from the second light-emitting assembly is greater than that of output light from the third light-emitting assembly.

17. A method for making an LED display device, **characterized by** comprising:

providing a driving substrate, wherein the driving substrate comprises a plurality of first pixel power supply electrodes and a plurality of second pixel power supply electrodes;

stacking a first light-emitting assembly on the driving substrate, wherein the first light-emitting assembly comprises a first light-emitting layer group, a plurality of first pixel defining electrodes, at least one second pixel defining electrode, and a plurality of first pixel transfer electrodes; the plurality of first pixel defining electrodes and at least one second pixel defining electrode are disposed on two side surfaces of the first light-emitting layer group, respectively; each first pixel defining electrodes is disposed on a side surface of the first light-emitting layer group facing the driving substrate, and configured to cooperate with the first light-emitting layer group and the second pixel defining electrode to form a first pixel; and each first pixel defining electrode is connected to a corresponding first pixel power supply electrode, and the plurality of first pixel transfer electrodes pass through the first light-emitting layer group; and stacking the second light-emitting assembly on a side of the first light-emitting assembly away from the driving substrate, wherein the second light-emitting assembly comprises a second light-emitting layer group, a plurality of third pixel defining electrodes, and at least one fourth pixel defining electrode; the plurality of third pixel defining electrodes and the at least one fourth pixel defining electrode are disposed on two side surfaces of the second light-emitting layer group, respectively; each third pixel defining electrode is disposed on a side surface of the second light-emitting layer group facing the first light-emitting assembly, and configured to cooperate with the second light-emitting layer group and the fourth pixel defining electrode to form a second pixel; in a stacking direction of the first light-emitting assembly and the second light-emitting assembly, a projection of the second pixel is staggered from that of the first pixel; and each third pixel defining electrode is electrically connected to a corresponding second pixel power supply electrode through a corresponding first pixel transfer electrode.

18. The method according to claim 17, wherein the driving substrate further comprises a plurality of third pixel power supply electrodes, the first light-emitting assembly further comprises a second pixel transfer electrode passing through the first light-emitting layer group, the second light-emitting assembly further comprises a third pixel transfer electrode passing through the second light-emitting layer group, and the third pixel transfer electrode is aligned with and connected to the second pixel transfer electrode;

the method further comprises:
stacking a third light-emitting assembly on a side of the second light-emitting assembly away from the first light-emitting assembly, wherein the third light-emitting assembly comprises a third light-emitting layer group, a plurality of fifth pixel defining electrodes, and at least one sixth pixel defining electrode; the plurality of fifth pixel defining electrodes and the at least one sixth pixel defining electrode are disposed on two side surfaces of the third light-emitting layer group, respectively; each fifth pixel defining electrode is disposed on a side surface of the third light-emitting layer group facing the second light-emitting assembly, and configured to cooperate with the third light-emitting layer group and the sixth pixel defining electrode to form a third pixel; in the stacking direction, a projection of the third pixel is staggered from that of the first pixel and that of the third pixel; and each fifth pixel defining electrode is electrically connected to a corresponding third pixel power supply electrode through the second pixel transfer electrode and the third pixel transfer electrode.

19. The method according to claim 17, wherein

the stacking the first light-emitting assembly on the driving substrate, comprises:

forming the first light-emitting layer group on a first temporary substrate, and forming the plurality of first pixel defining electrodes on a side surface of the first light-emitting layer group away from the first temporary substrate;
transferring the first light-emitting layer group on the driving substrate, and allowing each first pixel defining electrode to be electrically connected to the corresponding first pixel power supply electrode; and
forming the second pixel defining electrode on a side surface of the first light-emitting layer group away from the driving substrate, and forming the plurality of first pixel transfer electrodes passing through the first light-emitting layer group, wherein each first pixel transfer electrode is electrically connected to the corresponding second pixel power supply electrode;

the stacking the second light-emitting assembly on the side of the first light-emitting assembly away from the driving substrate, comprises:

forming the second light-emitting layer group on a second temporary substrate, and forming the plurality of third pixel defining electrodes on a side surface of the second light-emitting layer group away from the second temporary substrate;

transferring the second light-emitting layer group on the side of the first light-emitting layer group away from the driving substrate, and allowing each third pixel defining electrode to be electrically connected to the corresponding first pixel transfer electrode; and

forming the fourth pixel defining electrode on the side surface of the second light-emitting layer group away from the first light-emitting assembly.

20. The method according to claim 19, wherein

the driving substrate further comprises a plurality of third pixel power supply electrodes, and the stacking the first light-emitting assembly on the driving substrate, further comprises:

forming a second pixel transfer electrode that passes through the first light-emitting layer group and is electrically connected to the plurality of third pixel power supply electrodes;

the stacking the second light-emitting assembly on the side of the first light-emitting assembly away from the driving substrate, comprises:

forming a third pixel transfer electrode that passes through the second light-emitting layer group, wherein the third pixel transfer electrode is aligned with and connected to the second pixel transfer electrode;

the method further comprises:

forming a third light-emitting layer group on a third temporary substrate, and forming a plurality of fifth pixel defining electrodes on a side surface of the third light-emitting layer group away from the third temporary substrate;

transferring the third light-emitting layer group on a side of the second light-emitting layer group away from the first light-emitting layer group, and allowing each fifth pixel defining electrode to be electrically connected to a corresponding third pixel transfer electrode; and

forming a sixth pixel defining electrode on a side surface of the third light-emitting layer group away from the second light-emitting assembly.

21. The method according to claim 17, wherein the driving substrate further comprises a common power supply electrode, the first light-emitting assembly further comprises a first common extraction electrode, and the first light-emitting assembly further comprises a second common extraction electrode; the first light-emitting layer group comprises a first semiconductor layer, a first active layer, and a second semiconductor layer stacked in sequence, and the first semiconductor layer is disposed on a side surface of the first active layer facing the driving substrate; the second light-emitting layer group comprises a third semiconductor layer, a second active layer, and a fourth semiconductor layer stacked in sequence, and the third semiconductor layer is disposed on a side surface of the second active layer facing the first light-emitting assembly; the first common extraction electrode passes through the first semiconductor layer and the first active layer, and is electrically connected to the second semiconductor layer and/or the second pixel defining electrode; and the second common extraction electrode passes through the third semiconductor layer and the second active layer, and is electrically connected to the fourth semiconductor layer and/or the fourth pixel defining electrode;

the stacking the first light-emitting assembly on the driving substrate, further comprises:
allowing the first common extraction electrode to be electrically connected to the common power supply electrode, and forming a first common transfer electrode, wherein the first common transfer electrode passes through the first light-emitting layer group and is electrically connected to the common power supply electrode; the stacking the second light-emitting assembly on the side of the first light-emitting assembly away from the driving substrate, comprises: allowing the second common extraction electrode to be electrically connected to the first common transfer electrode.

FIG. 1

FIG. 2

240

210

2412

2411

250

P

FIG. 3

280    230

210

FIG. 4

1

FIG. 5

FIG. 6

providing the driving substrate, wherein the driving substrate includes the multiple first pixel power supply electrodes and the multiple second pixel power supply electrodes ⌐∼10

stacking the first light-emitting assembly on the driving substrate, wherein the first light-emitting assembly includes the first light-emitting layer group, the multiple first pixel defining electrodes, the at least one second pixel defining electrode, and the first pixel transfer electrode; the multiple first pixel defining electrodes and the at least one second pixel defining electrode are disposed on two side surfaces of the first light-emitting layer group, respectively; each first pixel defining electrode is disposed on the side surface of the first light-emitting layer group facing the driving substrate, and cooperates with the first light-emitting layer group and the corresponding second pixel defining electrode to form the first pixel; and each first pixel defining electrode is electrically connected to the corresponding first pixel power supply electrode, and the first pixel transfer electrode passes through the first light-emitting layer group ∼20

stacking the second light-emitting assembly on the side of the first light-emitting assembly away from the driving substrate, wherein the second light-emitting assembly includes the second light-emitting layer group, the multiple third pixel defining electrodes, and the at least one fourth pixel defining electrode; the multiple third pixel defining electrodes and the at least one fourth pixel defining electrode are disposed on two side surfaces of the second light-emitting layer group, respectively; each third pixel defining electrode is disposed on the side surface of the second light-emitting layer group facing the first light-emitting assembly, and cooperates with the second light-emitting layer group and the fourth pixel defining electrode to form the second pixel; in the stacking direction of the first light-emitting assembly and the second light-emitting assembly, the projection of the second pixel and the projection of the first pixel are staggered; and each third pixel defining electrode is electrically connected to the corresponding second pixel power supply electrode through the first pixel transfer electrode ∼30

stacking the third light-emitting assembly on the side of the second light-emitting assembly away from the first light-emitting assembly, wherein the third light-emitting assembly includes the third light-emitting layer group, the multiple fifth pixel defining electrodes, and the at least one sixth pixel defining electrode; the multiple fifth pixel defining electrodes and the at least one sixth pixel defining electrode are disposed on both sides of the third light-emitting layer group, respectively; each fifth pixel defining electrode is disposed on the side surface of the third light-emitting layer group facing the second light-emitting assembly, and cooperates with the third light-emitting layer group and the sixth pixel defining electrode to form the third pixel; the projection of the third pixel in the stacking direction is staggered from the projections of the first pixel and the third pixel in the stacking direction, and each fifth pixel defining electrode is electrically connected to the corresponding third pixel power supply electrode through the second pixel transfer electrode and the third pixel transfer electrode ⌐∼40

FIG. 7

forming the first light-emitting layer group on a first temporary substrate, and forming the multiple first pixel defining electrodes on a side surface of the first light-emitting layer group away from the first temporary substrate ～210

transferring the first light-emitting layer group to the driving substrate, and allowing each first pixel defining electrode to be electrically connected to the corresponding first pixel power supply electrode ～220

forming the second pixel defining electrode on the side surface of the first light-emitting layer group away from the driving substrate, and forming the first pixel transfer electrode that passes through the first light-emitting layer group and is electrically connected to the second pixel power supply electrode ～230

FIG. 8

forming the second light-emitting layer group on a second temporary substrate, and forming the multiple third pixel defining electrodes on a side surface of the second light-emitting layer group away from the second temporary substrate ～310

transferring the second light-emitting layer group to the side of the first light-emitting layer group away from the driving substrate, and allowing each third pixel defining electrode to be electrically connected to the corresponding first pixel transfer electrode ～320

disposing a fourth interlayer insulating layer on the side surface of the second light-emitting layer group away from the first light-emitting layer group ～330

FIG. 9

500

210
500

222
2211
210
500

220
221
210
500

250
220
221
210
500

2711
270
250
220
221
210
500

FIG. 10

FIG. 11

FIG. 12

FIG. 13

FIG. 14

FIG. 15

FIG. 16

FIG. 17

FIG. 18

FIG. 19

## INTERNATIONAL SEARCH REPORT

| International application No. |
|---|
| **PCT/CN2024/109229** |

| A. | CLASSIFICATION OF SUBJECT MATTER |
|---|---|

H01L27/15(2006.01)i

According to International Patent Classification (IPC) or to both national classification and IPC

| B. | FIELDS SEARCHED |
|---|---|

Minimum documentation searched (classification system followed by classification symbols)

IPC: H01L

Documentation searched other than minimum documentation to the extent that such documents are included in the fields searched

Electronic data base consulted during the international search (name of data base and, where practicable, search terms used)

VEN, CNABS, CNTXT, WOTXT, EPTXT, USTXT, CNKI, IEEE: 显示, 发光, 二极管, 驱动, 衬底, 基板, 像素, 电极, 叠, 交叠, 交错, 错开, 投影, display, light emitting, diode, drive, substrate, pixel, electrode, stack, stagger, projection

| C. | DOCUMENTS CONSIDERED TO BE RELEVANT |
|---|---|

| Category* | Citation of document, with indication, where appropriate, of the relevant passages | Relevant to claim No. |
|---|---|---|
| X | CN 110462850 A (HONG KONG BEIDA JADE BIRD DISPLAY LIMITED) 15 November 2019 (2019-11-15) description, paragraphs [0023]-[0052], and figures 1A-5 | 1-21 |
| X | CN 109216329 A (HONG FU JIN PRECISION INDUSTRY (SHENZHEN) CO., LTD. et al.) 15 January 2019 (2019-01-15) description, paragraphs [0025]-[0052], and figures 1-2 | 1-21 |
| A | CN 111081730 A (SHENZHEN INSTITUTE OF WIDE-BANDGAP SEMICONDUCTORS) 28 April 2020 (2020-04-28) entire document | 1-21 |
| A | US 2021098562 A1 (VUEREAL INC.) 01 April 2021 (2021-04-01) entire document | 1-21 |

☐ Further documents are listed in the continuation of Box C.   ☑ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **11 October 2024** | **17 October 2024** |

| Name and mailing address of the ISA/CN | Authorized officer |
|---|---|
| **China National Intellectual Property Administration (ISA/CN)** **China No. 6, Xitucheng Road, Jimenqiao, Haidian District, Beijing 100088** | |
| | Telephone No. |

Form PCT/ISA/210 (second sheet) (July 2022)

# EP 4 750 278 A1

| INTERNATIONAL SEARCH REPORT<br>Information on patent family members | | International application No.<br>**PCT/CN2024/109229** |

| Patent document<br>cited in search report | | | Publication date<br>(day/month/year) | Patent family member(s) | | | Publication date<br>(day/month/year) |
|---|---|---|---|---|---|---|---|
| CN | 110462850 | A | 15 November 2019 | TW | 201838203 | A | 16 October 2018 |
| | | | | TWI | 813562 | B | 01 September 2023 |
| | | | | US | 2020035653 | A1 | 30 January 2020 |
| | | | | US | 10658346 | B2 | 19 May 2020 |
| | | | | JP | 2020519001 | A | 25 June 2020 |
| | | | | JP | 7209634 | B2 | 20 January 2023 |
| | | | | EP | 3602639 | A1 | 05 February 2020 |
| | | | | EP | 3602639 | A4 | 09 September 2020 |
| | | | | EP | 3602639 | B1 | 26 July 2023 |
| | | | | SG | 11201908609 | VA | 30 October 2019 |
| | | | | AU | 2018239260 | A1 | 03 October 2019 |
| | | | | AU | 2018239260 | B2 | 13 May 2021 |
| | | | | US | 2019287949 | A1 | 19 September 2019 |
| | | | | US | 10600767 | B2 | 24 March 2020 |
| | | | | WO | 2018175338 | A1 | 27 September 2018 |
| | | | | EP | 4148811 | A1 | 15 March 2023 |
| | | | | AU | 2021206869 | A1 | 26 August 2021 |
| | | | | AU | 2021206869 | B2 | 16 February 2023 |
| | | | | SG | 10202111685 | WA | 30 December 2021 |
| | | | | KR | 20190127872 | A | 13 November 2019 |
| | | | | KR | 102304400 | B1 | 24 September 2021 |
| | | | | CN | 118281036 | A | 02 July 2024 |
| CN | 109216329 | A | 15 January 2019 | TW | 201907551 | A | 16 February 2019 |
| | | | | TWI | 672808 | B | 21 September 2019 |
| | | | | US | 2019013305 | A1 | 10 January 2019 |
| | | | | US | 10559557 | B2 | 11 February 2020 |
| | | | | US | 2021313308 | A1 | 07 October 2021 |
| | | | | US | 11955469 | B2 | 09 April 2024 |
| | | | | US | 2020144240 | A1 | 07 May 2020 |
| | | | | US | 11069669 | B2 | 20 July 2021 |
| | | | | CN | 109216329 | B | 08 September 2020 |
| CN | 111081730 | A | 28 April 2020 | WO | 2021115472 | A1 | 17 June 2021 |
| | | | | CN | 111081730 | B | 27 December 2022 |
| US | 2021098562 | A1 | 01 April 2021 | US | 2020273945 | A1 | 27 August 2020 |
| | | | | WO | 2020170222 | A1 | 27 August 2020 |
| | | | | CN | 111613574 | A | 01 September 2020 |
| | | | | TW | 202105674 | A | 01 February 2021 |
| | | | | US | 2021343828 | A1 | 04 November 2021 |
| | | | | US | 11552163 | B2 | 10 January 2023 |

Form PCT/ISA/210 (patent family annex) (July 2022)

41

**EP 4 750 278 A1**

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 2023108901096